# EUROPEAN PATENT SPECIFICATION

(11) **EP 4 258 371 B1**
(45) Date of publication and mention of the grant of the patent: **28.10.2026**
(21) Application number: 21914270.0
(22) Date of filing: 27.12.2021
(51) Int. Cl.: G11C 11/16, G11C 11/56, H10B 61/00, H10N 50/01, H10N 50/10, H10N 50/80

(54) **STORAGE DEVICE AND PREPARATION METHOD, READ-WRITE METHOD, STORAGE CHIP, AND ELECTRONIC DEVICE**
SPEICHERVORRICHTUNG UND HERSTELLUNGSVERFAHREN, LESE-SCHREIBVERFAHREN, SPEICHERCHIP UND ELEKTRONISCHE VORRICHTUNG
DISPOSITIF DE STOCKAGE ET PROCÉDÉ DE PRÉPARATION, PROCÉDÉ DE LECTURE-ÉCRITURE, PUCE DE STOCKAGE ET DISPOSITIF ÉLECTRONIQUE

(30) Priority: 31.12.2020 CN 202011631814
(43) Date of publication of application: 11.10.2023
(73) Proprietor: Huawei Technologies Co., Ltd., Shenzhen, Guangdong 518129 (CN)
(72) Inventor: HE, Liang, Shenzhen, Guangdong 518129 (CN); YAN, Xin, Shenzhen, Guangdong 518129 (CN); ZHAO, Yafei, Shenzhen, Guangdong 518129 (CN); NING, Jiai, Shenzhen, Guangdong 518129 (CN); ZHAO, Junfeng, Shenzhen, Guangdong 518129 (CN); TANG, Wentao, Shenzhen, Guangdong 518129 (CN)
(74) Representative: Körber, Martin Hans
(86) International application number: PCT/CN2021/141685
(87) International publication number: WO 2022/143534

(56) References cited:
- CN-A- 108 538 328
- CN-A- 109 923 686
- CN-A- 109 923 686
- US-A1- 2015 213 868
- US-A1- 2019 259 810
- US-B1- 10 381 406

## Description

### TECHNICAL FIELD

This application relates to the field of storage technologies, and in particular, to a storage component, a preparation method, a reading/writing method, a storage chip, and an electronic device.

### BACKGROUND

A spin orbit torque magnetic random access memory (SOT-MRAM) has become a research hotspot in fields of spin electronics and magnetic information storage due to its fast write speed, low write current, and good compatibility.

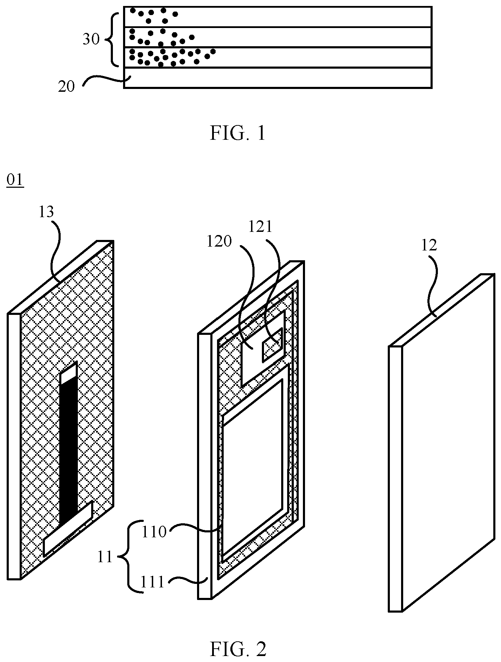

Currently, the SOT-MRAM has only two states: a high resistive state and a low resistive state. Therefore, a binary read/write mode is usually used, and a storage density of the SOT-MRAM is relatively low. To improve the storage density of the SOT-MRAM by increasing a quantity of storage states of the SOT-MRAM, a person skilled in the art proposes an SOT-MRAM. As shown in FIG. 1, the SOT-MRAM includes a spin orbit coupling (SOC) layer 20 and a magnetic tunnel junction (MTJ) 30 arranged on the SOC layer 20. There are doped ions in the MTJ 30, and the doped ions have a concentration gradient. In a preparation process, the SOC layer 20 having a spin orbit coupling effect is first grown on a substrate, and then the MTJ 30 is grown. Then, a mask layer is formed in partial area of the MTJ 30, and then ions are injected, so as to inject the ions into an area that is of the MTJ 30 and that is not masked. Then, thermal annealing is performed, so that a small quantity of doped ions are also diffused in the area of the MTJ 30 in which no doped ions are injected. In this way, in a plane in which the SOC layer 20 is located and in a direction perpendicular to a current direction, the doped ions in the MTJ 30 have a concentration gradient.

Based on the SOT-MRAM shown in FIG. 1, because there is a concentration gradient in the MTJ 30, deflection directions after magnetization are also different, and symmetrical damage is formed in the direction perpendicular to the current direction. Specifically, when a current is input into the SOC layer 20, no external magnetic field is required, and a magnetic resistance is linearly output with the current in a multi-state manner, so that multi-state storage is implemented.

However, a preparation process of the SOT-MRAM shown in FIG. 1 is relatively complex, and it is difficult to implement an instrument and a process for performing directional ion doping on the MTJ 30. In addition, after directional doping is performed on the MTJ 30, although multi-state storage can be implemented, a resistance change range of the MTJ 30 (that is, a difference or a ratio between a highest resistance and a lowest resistance of the MTJ 30) is still the same as that of an MTJ 30 in the SOT-MRAM that has only the high resistive state and the low resistive state, and a higher resistance change range cannot be obtained. However, the quantity of storage states is increased, while the resistance change range remains unchanged (for example, for a resistance change range of 1000 ohms to 2500 ohms, previously, 1000 ohms corresponds to one storage state, and 2500 ohms corresponds to one storage state; and now, 1000 ohms corresponds to one storage state, 1750 ohms corresponds to one storage state, and 2500 ohms corresponds to one storage state). Consequently, a difference between resistance values corresponding to the storage states is relatively small, and accuracy of SOT-MRAM read/write is affected.

US 10 381 406 B1 discloses an integrated circuit including a plurality of MRAM structures. The integrated circuit further includes a first lower MTJ stack with the first lower MTJ stack including a first lower free layer. The integrated circuit further includes a spin orbit torque coupling layer overlying the first lower MTJ stack. The integrated circuit further includes a first upper MTJ stack overlying the spin orbit torque coupling layer and the first lower MTJ stack with the first upper MTJ stack including a first upper free layer. The switching energy barrier for each of the first lower free layer and the first upper free layer is reduced in the presence of an electrical voltage passing through each of the MTJ stacks. The first lower free layer and said first upper free layer are configured to have magnetizations independent of each other.

US 2015/213868 A1 discloses a three-phase non-volatile flip-flop (NVFF), which includes a master stage formed from a dual giant spin Hall effect (GSHE)-magnetic tunnel junction (MTJ) structure, with a first GSHE-MTJ and a second GSHE-MTJ coupled between a first combined terminal and a second combined terminal, and a slave stage formed from a first inverter cross-coupled with a second inverter. A first data value is read out from the slave stage during a read phase of the same clock cycle that a second data value is written into the master stage during a write phase. The three-phase NVFF includes three control signals, for controlling an initialization phase of the slave stage, the read phase, and the write phase.

CN 109 923 686 A discloses a quaternary spir Hall memory comprising a first magnetic junction having a fixed magnetic layer and a 4-state free magnetic layer; a second magnetic junction having a fixed magnetic layer and a 4-state free magnetic layer; and a first layer of spin orbit coupling material adjacent to the first magnetic junction and the second magnetic junction via their respective 4-state free magnetic layers.

### SUMMARY

Embodiments of this application provide a storage chip, a preparation method, a reading/writing method, and an electronic device, to resolve a problem that a quantity of storage states of an SOT-MRAM is increased while a storage state change range remains unchanged. The invention is defined in the independent claims. Advantageous features are defined in the dependent claims.

### BRIEF DESCRIPTION OF DRAWINGS

FIG. 1 is a schematic diagram of a structure of a storage component according to a related technology;
FIG. 2 is a schematic diagram of a structure of an electronic device according to an embodiment of this application;
FIG. 3 is a schematic diagram of a structure of a storage component according to an embodiment of this application;
FIG. 4a is a schematic diagram of a storage state of a storage component according to an embodiment of this application;
FIG. 4b is a schematic diagram of a storage state of another storage component according to an embodiment of this application;
FIG. 4c is a schematic diagram of a storage state of still another storage component according to an embodiment of this application;
FIG. 4d is a schematic diagram of a storage state of yet another storage component according to an embodiment of this application;
FIG. 5a is a flowchart of a preparation method of a storage component according to an embodiment of this application;
FIG. 5b-1 and FIG. 5b-2 are a schematic diagram of a preparation process of a storage component according to an embodiment of this application;

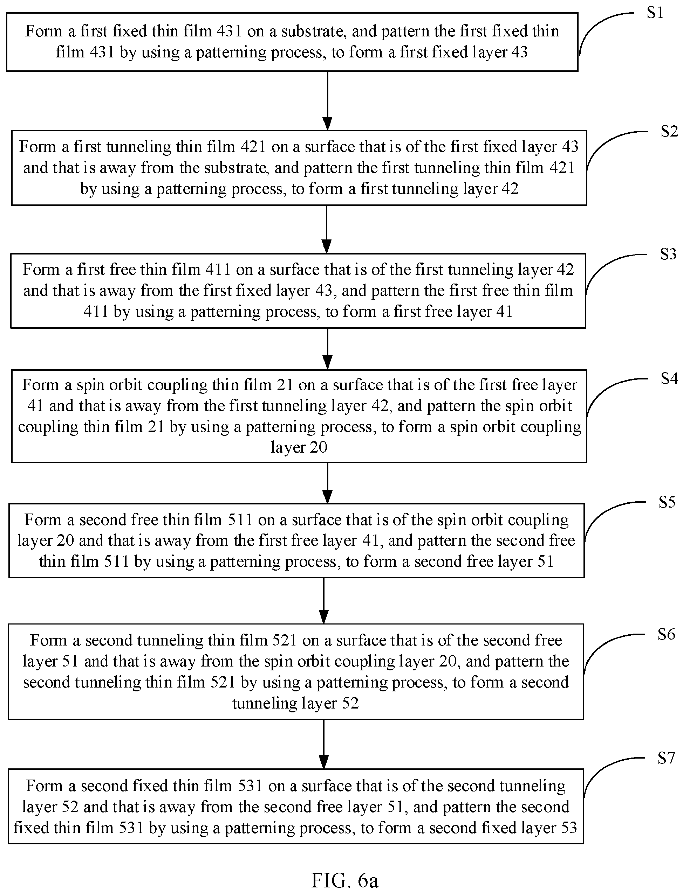

FIG. 6a is a flowchart of another preparation method of a storage component according to an embodiment of this application;
FIG. 6b-1 and FIG. 6b-2 are a schematic diagram of another preparation process of a storage component according to an embodiment of this application;

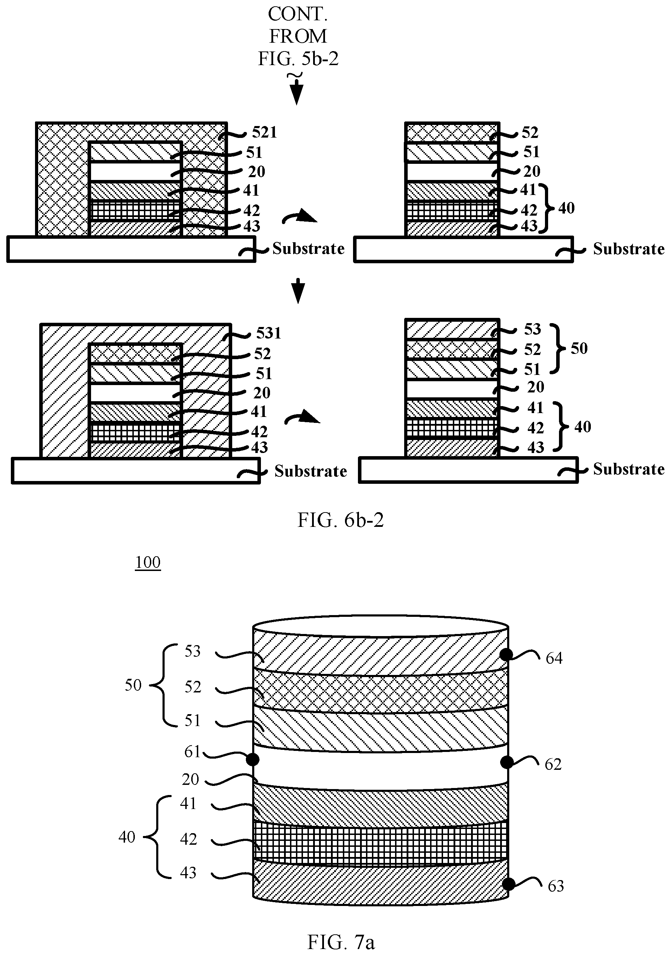

FIG. 7a is a schematic diagram of a structure of another storage component according to an embodiment of this application;

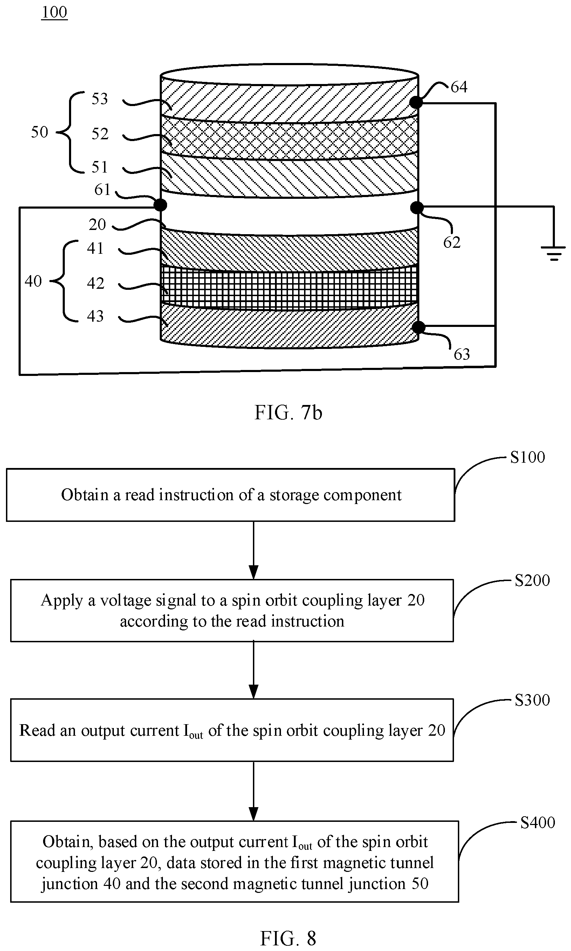

FIG. 7b is a schematic diagram of a structure of still another storage component according to an embodiment of this application;
FIG. 8 is a flowchart of a reading method of a storage component according to an embodiment of this application;

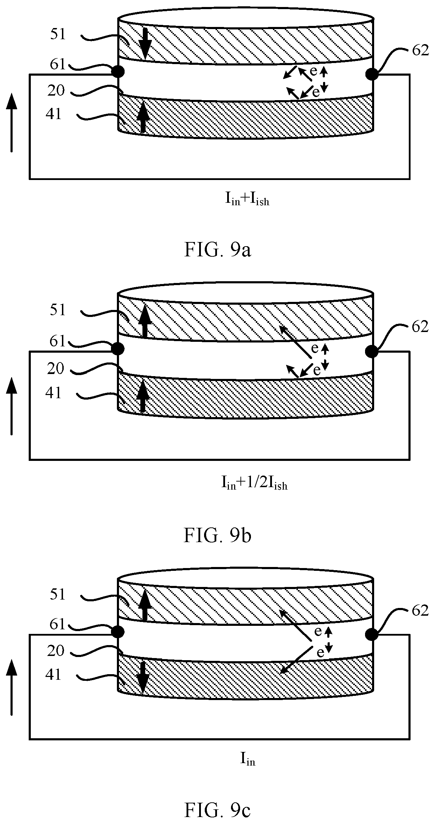

FIG. 9a is a schematic diagram of a reading principle of a storage component according to an embodiment of this application;
FIG. 9b is a schematic diagram of another reading principle of a storage component according to an embodiment of this application;
FIG. 9c is a schematic diagram of still another reading principle of a storage component according to an embodiment of this application;

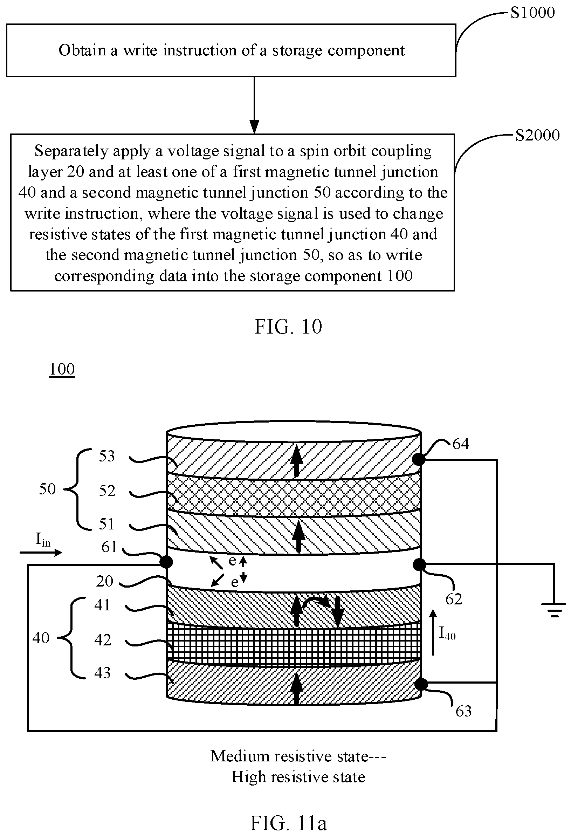

FIG. 10 is a flowchart of a writing method of a storage component according to an embodiment of this application;
FIG. 11a is a schematic diagram of a writing principle of a storage component according to an embodiment of this application;

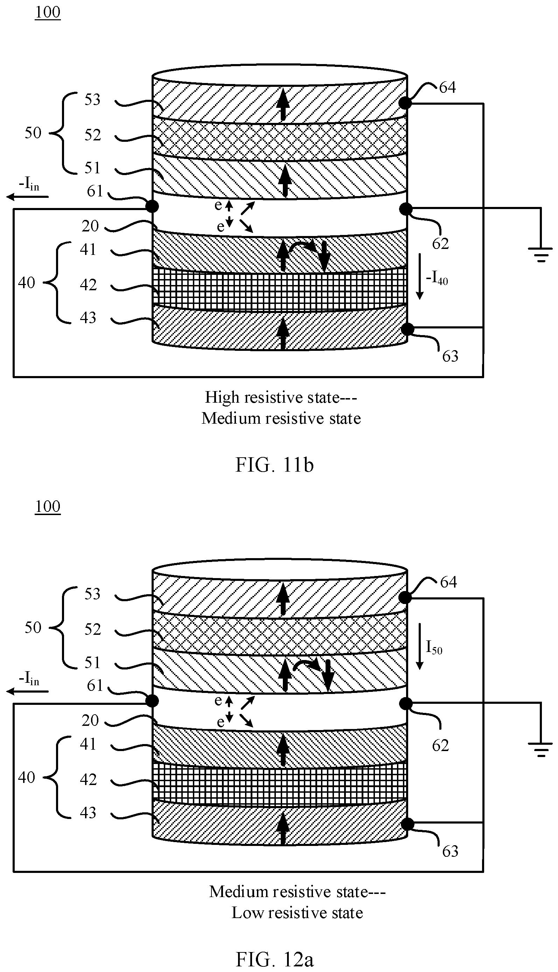

FIG. 11b is a schematic diagram of another writing principle of a storage component according to an embodiment of this application;
FIG. 12a is a schematic diagram of still another writing principle of a storage component according to an embodiment of this application;

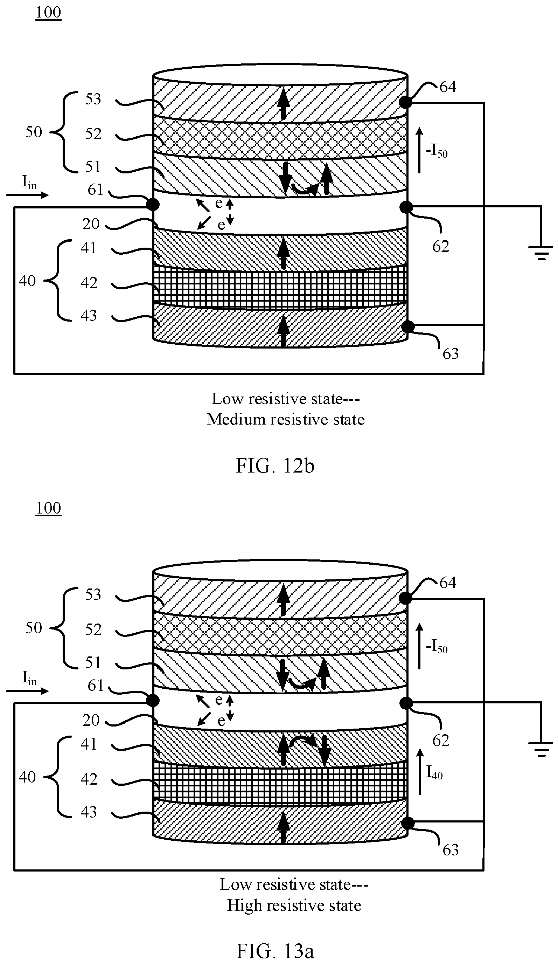

FIG. 12b is a schematic diagram of yet another writing principle of a storage component according to an embodiment of this application;
FIG. 13a is a schematic diagram of still yet another writing principle of a storage component according to an embodiment of this application;

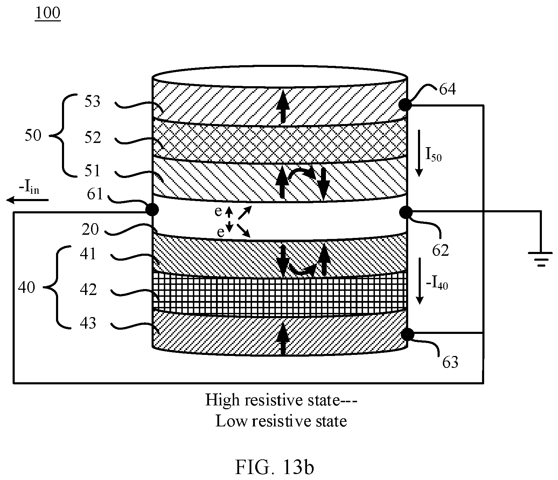

FIG. 13b is a schematic diagram of a further writing principle of a storage component according to an embodiment of this application;

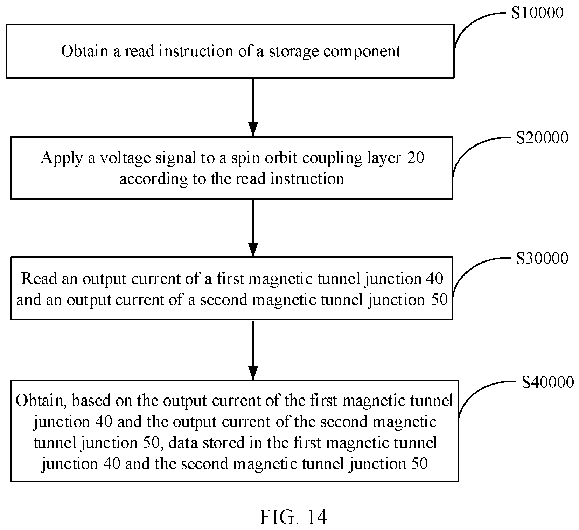

FIG. 14 is a flowchart of another reading method of a storage component according to an embodiment of this application;

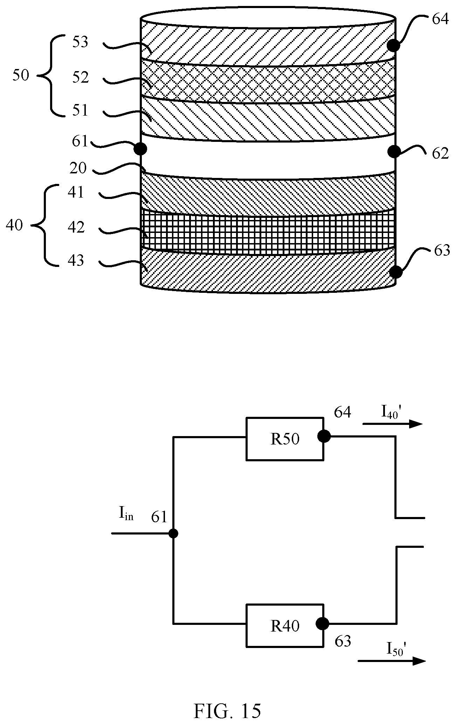

FIG. 15 is an equivalent circuit diagram of a storage component according to an embodiment of this application;

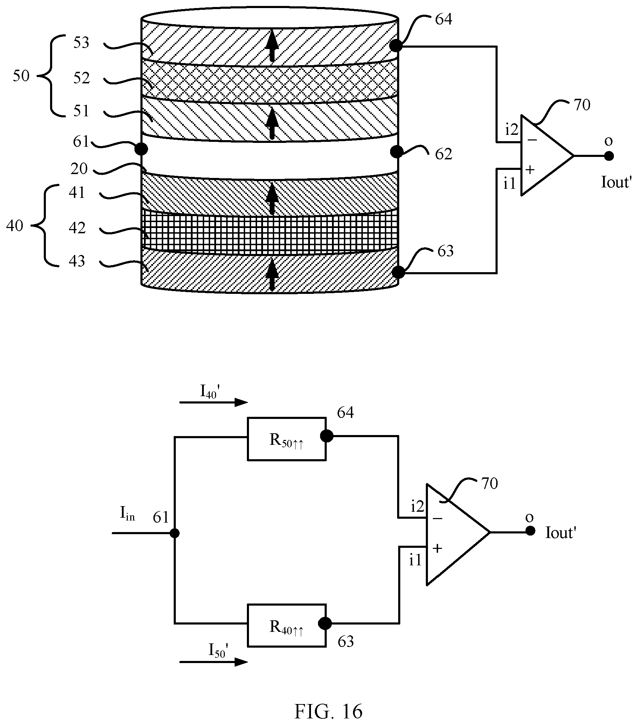

FIG. 16 is a schematic diagram of yet another reading principle of a storage component according to an embodiment of this application;

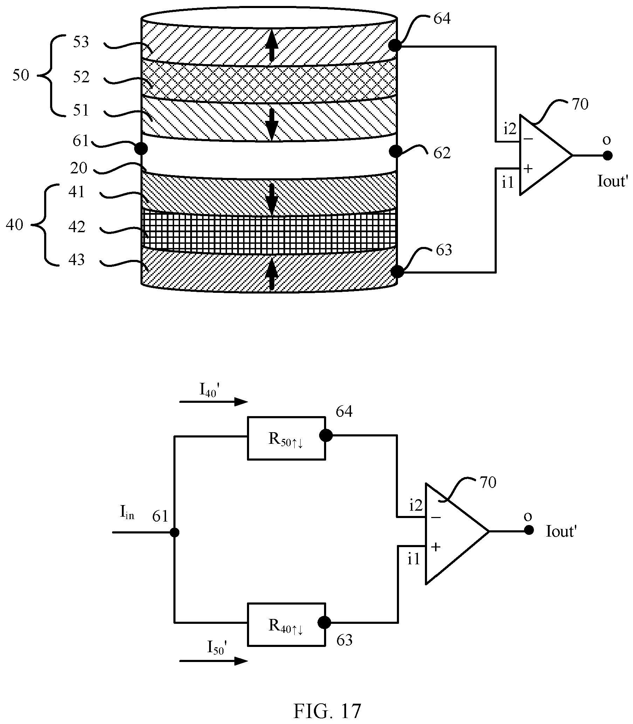

FIG. 17 is a schematic diagram of still yet another reading principle of a storage component according to an embodiment of this application;

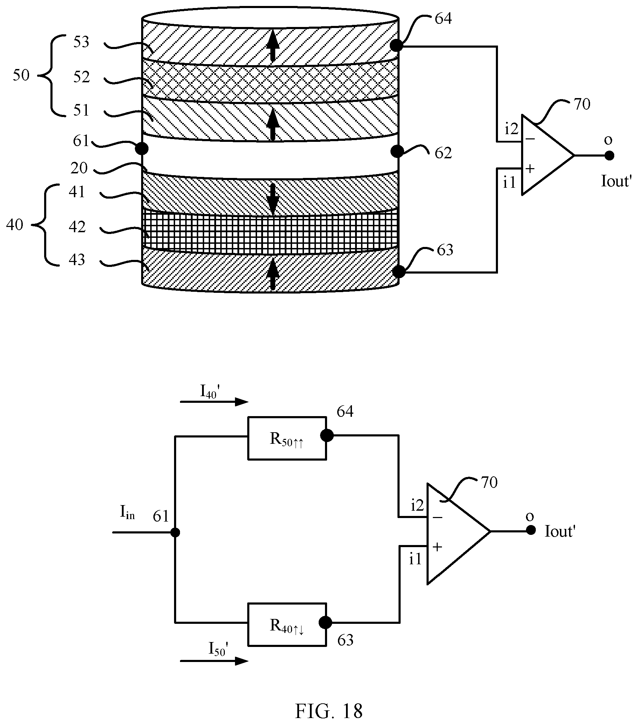

FIG. 18 is a schematic diagram of a further reading principle of a storage component according to an embodiment of this application;

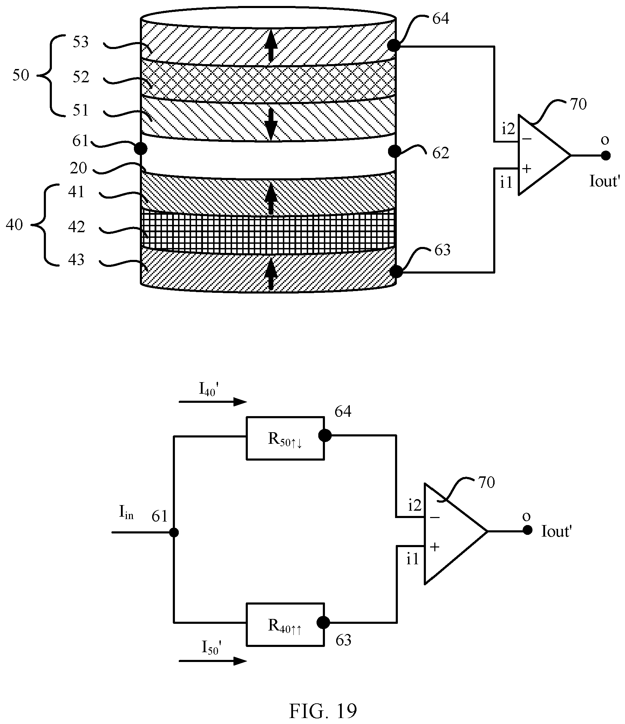

FIG. 19 is a schematic diagram of a still further reading principle of a storage component according to an embodiment of this application;

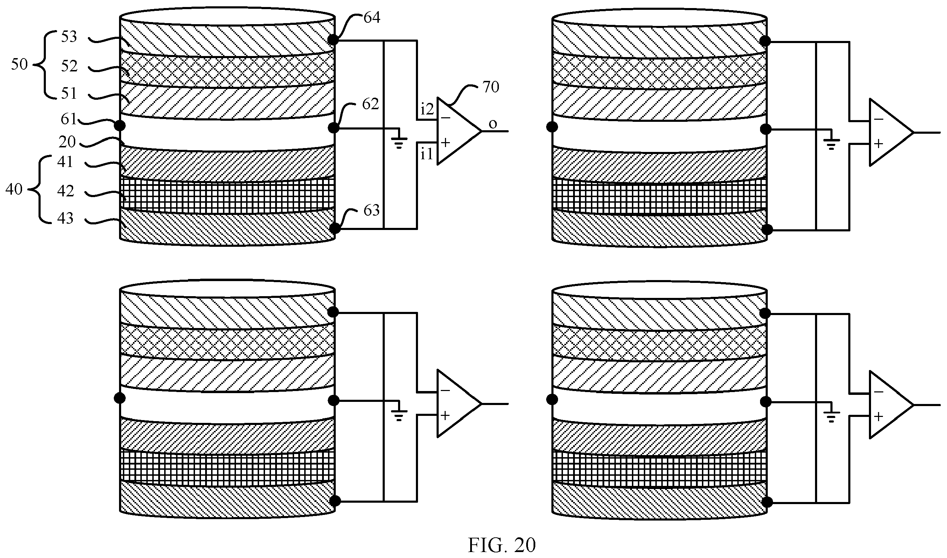

FIG. 20 is a schematic diagram of a structure of a storage chip according to the invention; and

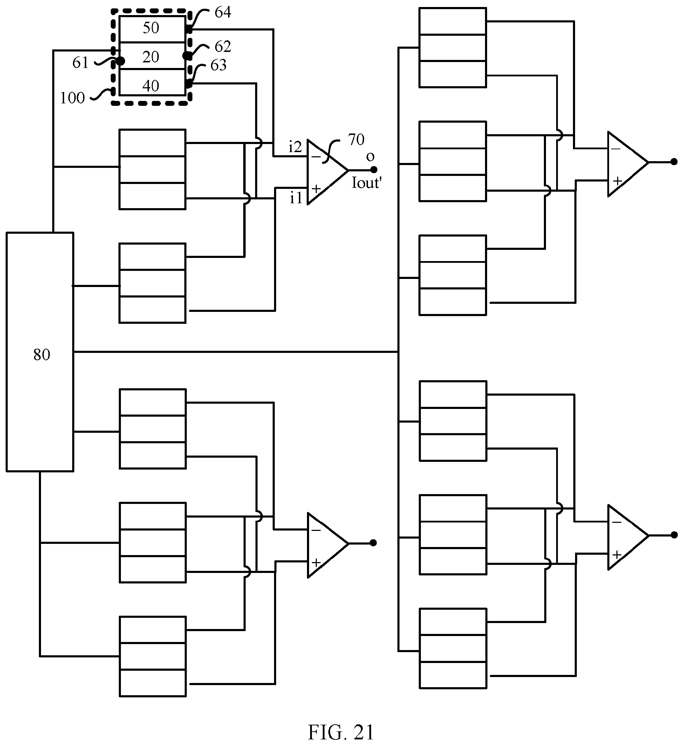

FIG. 21 is a schematic diagram of a structure of another storage chip according to the invention.

### DESCRIPTION OF EMBODIMENTS

The following describes the technical solutions in embodiments of this application with reference to the accompanying drawings in embodiments of this application. It is clearly that the described embodiments are merely some but not all the embodiments of this application.

The following terms "first", "second" and the like are merely intended for ease of description, and shall not be understood as an indication or implication of relative importance or implicit indication of a quantity of indicated technical features. Therefore, a feature limited by "first ", "second" and the like may explicitly indicate or implicitly include one or more such features. In description of this application, unless otherwise stated, "multiple" means two or more than two.

In addition, in embodiments of this application, orientation terms such as "upper", "lower", "left", and "right" may be defined by, but are not limited to, orientations of components schematically placed in the accompanying drawings. It should be understood that these orientation terms may be relative concepts, are used for description and clarification of "relative to", and may be changed correspondingly based on changes in placement orientations of the components in the accompanying drawings.

In this application, unless otherwise specified and limited, the term "connection" should be understood in a broad sense. For example, the "connection" may be a fixed connection, a detachable connection, an integration, a direct connection, or an indirect connection by using an intermediate medium. In addition, the term "electrical connection" may be a direct electrical connection, or may be an indirect electrical connection through an intermediate medium.

An embodiment of this application provides an electronic device. The electronic device may be an electronic product such as a mobile phone, a tablet computer (pad), a television, an intelligent wearable product (for example, a smartwatch or a smart band), a virtual reality (VR) terminal device, an augmented reality (AR) terminal device, a small rechargeable household appliance (for example, a soybean milk machine or a robot vacuum cleaner), and an uncrewed aerial vehicle. A specific form of the electronic device is not specifically limited in this embodiment of this application.

An example in which any one of the foregoing electronic devices is a mobile phone is used. As shown in FIG. 2, the electronic device 01 may include a middle frame 11, a rear housing 12, and a display screen 13. The middle frame 11 includes a bearing plate 110 configured to bear the display screen 13, and a frame 111 surrounding the bearing plate 110. The electronic device 01 may include a circuit board 120 disposed on a surface that is of the bearing plate 110 and that faces the rear housing 12. The circuit board 120 is, for example, a printed circuit board (PCB). The electronic device 01 further includes some electronic components 121 disposed on the circuit board 120. The electronic components 121 include, for example, a storage chip. The rear housing 12 is connected to the middle frame 11, so as to prevent external vapor and dust from affecting performance of the circuit board 120 and the electronic components 121.

The storage chip includes a storage component and a peripheral circuit configured to perform read/write on the storage component.

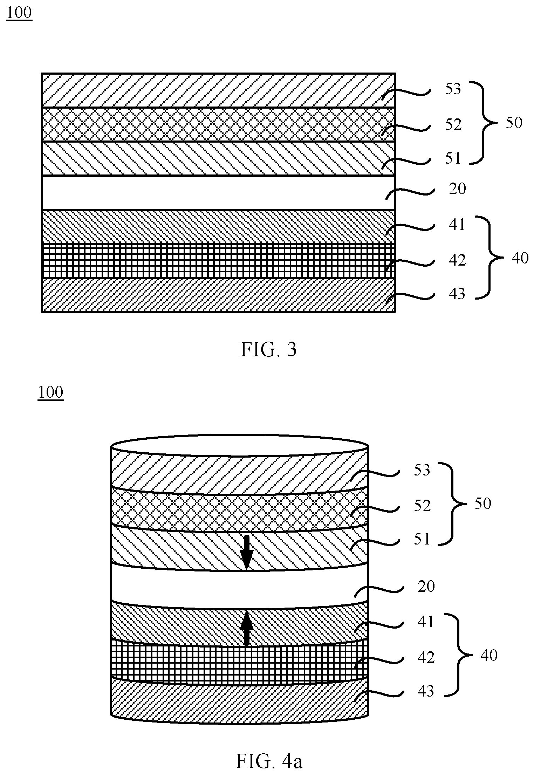

An embodiment of this application provides a storage component. As shown in FIG. 3, a storage component 100 includes a first magnetic tunnel junction (MTJ) 40, a spin orbit coupling (SOC) layer 20, and a second magnetic tunnel junction 50 that are sequentially arranged in a stacked manner.

In a possible embodiment, a structure of the first magnetic tunnel junction 40 is shown in FIG. 3. The first magnetic tunnel junction 40 includes a first free layer 41, a first tunneling layer 42, and a first fixed layer 43 that are sequentially arranged in a stacked manner.

With respect to a structure of the first free layer 41, to simplify a preparation process, in a possible embodiment, the first free layer 41 is of a single-layer film layer structure.

In another possible embodiment, the first free layer 41 is of a laminated structure including multiple film layers.

Materials and thicknesses of the multiple film layers may be the same or may be different.

The first free layer 41 is designed as the laminated structure including the multiple film layers, so that a coercive force of the first free layer 41 can be reduced, and a magnetization direction of the first free layer 41 is reversed more easily.

Considering that a thickness design of the first free layer 41 affects a magnetization direction and a coercive force of the first free layer 41, in some embodiments, the thickness of the first free layer 41 is 2 to 40 nm. For example, the thickness of the first free layer 41 is 10 nm, 15 nm, 20 nm, 25 nm, 30 nm or 35 nm.

A material making up the first free layer 41 may be, for example, a ferromagnetic material (FM) having vertical magnetic anisotropy. Such a material that can be magnetized to a saturated state with a magnetic susceptibility greater than 0 under an action of only a very small magnetic field (where a value of the magnetic susceptibility is greater than the order of 10 to 10E6) and that maintains a magnetization state after the magnetic field action disappears (namely, a spontaneous magnetization phenomenon) is referred to as a ferromagnetic material.

In a possible embodiment, a material of each film layer of the first free layer 41 includes Co (cobalt), Mn (manganese), Si (silicon), Fe (ferro), B (boron), Al (aluminum), Ge (germanium), Te (tellurium), Cr (chromium), O (oxygen), Ni (nickel), Pt (platinum), or the like. For example, the material of each film layer of the first free layer 41 is Co2MnSi (cobalt manganese silicon), CoFeB (cobalt iron boron), Co2FeAl (cobalt iron aluminum), Fe3GeTe2 (iron germanium tellurium), CrGeTe3 (chromium germanium telluride), CrSiTe3 (chromium silicon telluride), CrTe2 (chromium ditelluride), Cr2Te3 (chromium telluride), CoFe (ferric cobalt), NiFe (ferric nickel), FePt (iron platinum), Fe3O4 (ferrosoferric oxide), Fe, Co, Pt, or the like.

A material making up the first tunneling layer 42 may be, for example, a metal oxide having a tunneling characteristic. In a possible embodiment, the material of the first tunneling layer 42 is an oxide of an element such as Mg (magnesium) and Al, or a combination of oxides of multiple elements. For example, the material of the first tunneling layer 42 is MgO (magnesium oxide), Al2O3 (aluminum oxide), MgAl2O4 (magnesium aluminum oxide), or the like.

A thickness of the first tunneling layer 42 only needs to be enough to form a tunneling barrier layer (or understood as having a quantum tunneling effect). If the first tunneling layer 42 is excessively thin, and a service life of the first tunneling layer is affected; or if the first tunneling layer 42 is excessively thick, a voltage written into the storage component is excessively high, and power consumption cannot be reduced.

In some embodiments, the thickness of the first tunneling layer 42 is 0.8 to 5 nm. For example, the thickness of the first tunneling layer 42 is 1 nm, 1.5 nm, 2 nm, 2.5 nm, 3 nm, 3.5 nm, 4 nm or 4.5 nm.

For the first fixed layer 43, reference may be made to the foregoing related description about the first free layer 41. Details are not described herein again. Certainly, it may be understood that, a coercive force of the first fixed layer 43 may be made to be greater than that of the first free layer 41 by adjusting a composition and a ratio of a film layer and a thickness of the film layer.

As shown in FIG. 3, the spin orbit coupling layer 20 and the first magnetic tunnel junction 40 are arranged in a stacked manner, and the spin orbit coupling layer 20 is located on one side that is of the first free layer 41 and that is away from the first tunneling layer 42.

With respect to a structure of the spin orbit coupling layer 20, to simplify a preparation process, in a possible embodiment, the spin orbit coupling layer 20 is of a single-layer film layer structure.

In another possible embodiment, the spin orbit coupling layer 20 is of a laminated structure including multiple film layers.

Materials of the multiple film layers may be the same or may be different.

The spin orbit coupling layer 20 is designed as the laminated structure including the multiple film layers, so that the spin orbit coupling layer 20 can form a stronger spin Hall effect, and a write current is reduced.

Considering that a thickness of the spin orbit coupling layer 20 affects efficiency of the spin orbit coupling layer 20 reverting magnetization directions of the first free layer 41 and a second free layer and growth quality of the spin orbit coupling layer 20 in a thin film growth process, in some embodiments, the thickness of the spin orbit coupling layer 20 is 2 to 30 nm. For example, the thickness of the spin orbit coupling layer 20 is 10 nm, 15 nm, 20 nm, or 25 nm.

A material making up the spin orbit coupling layer 20 may be, for example, a material having strong spin orbit coupling performance. In a possible embodiment, the material of the spin orbit coupling layer 20 includes Ta (tantalum), P (phosphorus), W (tungsten), Bi (bimuth), Te (tellurium), Se (selenium), Sb (monymony), Sr (strontium), Ir (irium), O, C (carbon), Zr (zirconium), or the like. For example, the material of the spin orbit coupling layer 20 is a heavy metal monomer, an oxide, graphene, or a topological insulator. For example, the material of the spin orbit coupling layer 20 is Ta, P, W, Bi2Te3 (bismuth telluride), Bi2Se3 (bismuth selenide), BiSbTeSe2 (BSTS), Sr2IrO4 (strontium iridate), ZrBi2 (zirconium bismuth), or the like.

In a possible embodiment, a structure of the second magnetic tunnel junction 50 is shown in FIG. 3. The second magnetic tunnel junction 50 includes a second free layer 51, a second tunneling layer 52, and a second fixed layer 53 that are sequentially arranged in a stacked manner.

As shown in FIG. 3, the second free layer 51 is arranged on the spin orbit coupling layer 20. In other words, the first free layer 41 and the second free layer 51 are arranged on two opposite surfaces of the spin orbit coupling layer 20.

A material and a structure of the second free layer 51 may be the same as those of the first free layer 41. Refer to the foregoing description about the first free layer 41. Details are not described herein again.

Similarly, a material and a structure of the second tunneling layer 52 may be the same as those of the first tunneling layer 42. Refer to the foregoing description about the first tunneling layer 42. Details are not described herein again.

Similarly, a material and a structure of the second fixed layer 53 may be the same as those of the first fixed layer 43. Refer to the foregoing descriptions about the first fixed layer 43. Details are not described herein again.

It should be noted that a thickness of the second free layer 51 may be the same as or different from that of the first free layer 41. A thickness of the second tunneling layer 52 may be the same as or different from that of the first tunneling layer 42. A thickness of the second fixed layer 53 may be the same as or different from that of the first fixed layer 43.

Performance (for example, a read/write time and read/write power consumption) of the storage component 100 may be adjusted by adjusting thicknesses of the film layers of the first magnetic tunnel junction 40, the second magnetic tunnel junction 50, and the spin orbit coupling layer 20.

Based on the storage component 100 shown in FIG. 3, a principle of the first magnetic tunnel junction 40 is the same as that of the second magnetic tunnel junction 50. The first magnetic tunnel junction 40 is used as an example. For the first magnetic tunnel junction 40, paralleling or anti-paralleling between a magnetization direction of the first free layer 41 and a magnetization direction of the first fixed layer 43 is adjusted based on a spin transfer torque (STT) effect.

In a magnetic tunnel junction, when a current flows from one magnetic layer (fixed layer) to another weaker magnetic layer (free layer), a spin angular momentum in a direction the same as a magnetization direction of the fixed layer is first obtained. When the spin polarization current diffuses into the free layer, the spin polarization current interacts with magnetization of the free layer, causing a transverse component of the spin polarization current to be transferred. Due to the angular momentum conservation, the transferred transverse component will act on the free layer in a form of a torque, which forces a magnetization direction of the free layer to be close to that of the fixed layer. This torque is called a spin transfer torque.

For the spin orbit coupling layer 20, reversing of magnetization directions of the first free layer 41 and the second free layer 51 is induced based on a spin orbit torque (SOT) effect.

A spin orbit torque means that: A spin flow generated by induction of a charge flow of the spin orbit coupling layer 20 is used to generate a spin transfer torque based on a spin orbit coupling effect, so as to induce reversing of a magnetization direction of a magnetic metal material of the free layer. Spin orbit coupling refers to the interaction of a particle's spin motion and its orbital motion in the quantum mechanical system.

According to the storage component 100 provided in this embodiment of this application, under a joint action of the first magnetic tunnel junction 40, the second magnetic tunnel junction 50, and the spin orbit coupling layer 20, resistive states of the first magnetic tunnel junction 40 and the second magnetic tunnel junction 50 are adjusted by adjusting magnetization directions of the first free layer 41 and the second free layer 51, so as to adjust a storage state corresponding to the storage component 100.

As shown in FIG. 4a, when the magnetization direction of the first free layer 41 is upward, and the magnetization direction of the second free layer 51 is downward, namely, when the magnetization direction of the first free layer 41 is opposite to that of the second free layer 51, a spin-down spin carrier in the spin orbit coupling layer 20 is bounced back because a spin direction of the spin-down spin carrier is opposite to the magnetization direction of the first free layer 41, and a spin-up spin carrier in the spin orbit coupling layer 20 is bounced back because the spin-up spin carrier is opposite to the magnetization direction of the second free layer 51. In other words, spin directions of the spin flow of the spin orbit coupling layer 20 may be opposite to both the magnetization direction of the first free layer 41 and the magnetization direction of the second free layer 51. In this way, an inverse spin Hall (ISH) effect is generated, all spin carriers are bounced back to the spin orbit coupling layer 20, and the spin orbit coupling layer 20 obtains an additional inverse spin Hall current Iish. This corresponds to a high current state of the storage component 100, namely, corresponds to a low resistive state of the storage component 100.

The inverse spin Hall effect refers to that a spin current that is reversed in a vertical direction is converted into a charge flow in a direction parallel to an existing current direction when no external magnetic field is applied, and a charge current characteristic is reflected in a macroscopic manner.

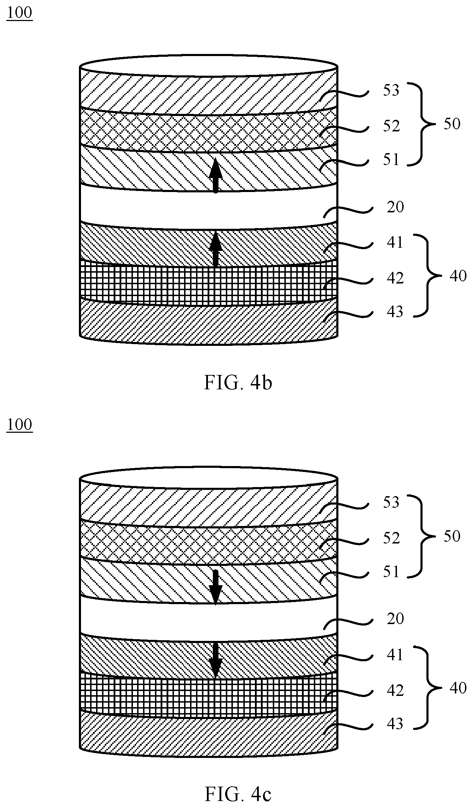

As shown in FIG. 4b, when the magnetization direction of the first free layer 41 is upward, and the magnetization direction of the second free layer 51 is also upward, namely, when the magnetization direction of the first free layer 41 is the same as that of the second free layer 51, a spin-down spin carrier in the spin orbit coupling layer 20 is bounced back because a spin direction of the spin-down spin carrier is opposite to the magnetization direction of the first free layer 41, and a spin-up spin carrier in the spin orbit coupling layer 20 diffuses into the second free layer 51 because the spin-up spin carrier is the same as that of the second free layer 51. In other words, spin directions of the spin flow of the spin orbit coupling layer 20 may be opposite to the magnetization direction of the first free layer 41 and the same as the magnetization direction of the second free layer 51. In this way, an inverse spin Hall effect is generated, half of spin carriers are bounced back to the spin orbit coupling layer 20, and the spin orbit coupling layer 20 obtains a relatively small additional current 1/2Iish. This corresponds to a medium current state of the storage component 100, namely, corresponds to a medium resistive state of the storage component 100.

As shown in FIG. 4c, when the magnetization direction of the first free layer 41 is downward, and the magnetization direction of the second free layer 51 is also downward, namely, when the magnetization direction of the first free layer 41 is the same as that of the second free layer 51, a spin-up spin carrier in the spin orbit coupling layer 20 is bounced back because the spin-up spin carrier is opposite to the magnetization direction of the second free layer 51, a spin-down spin carrier in the spin orbit coupling layer 20 diffuses into the first free layer 41 because the spin-down spin carrier is the same as the magnetization direction of the first free layer 41. In other words, spin directions of the spin flow of the spin orbit coupling layer 20 may be the same as the magnetization direction of the first free layer 41 and opposite to the magnetization direction of the second free layer 51. In this way, an inverse spin Hall effect is generated, half of spin carriers are bounced back to the spin orbit coupling layer 20, and the spin orbit coupling layer 20 obtains a relatively small additional current 1/2Iish. This corresponds to a medium current state of the storage component 100, namely, corresponds to a medium resistive state of the storage component 100.

For ease of description, the following describes the medium resistive state of the storage component 100 by using only an example shown in FIG. 4b in which the magnetization direction of the first free layer 41 is upward and the magnetization direction of the second free layer 51 is also upward.

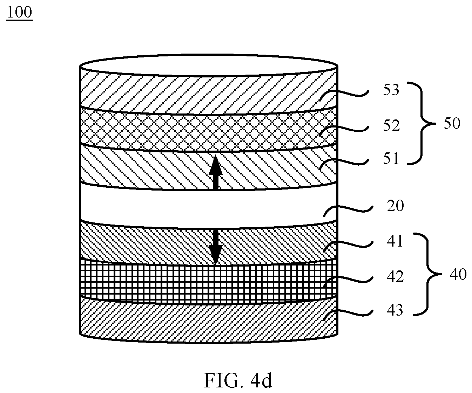

As shown in FIG. 4d, when the magnetization direction of the first free layer 41 is downward, and the magnetization direction of the second free layer 51 is upward, namely, when the magnetization direction of the first free layer 41 is opposite to that of the second free layer 51, a spin-down spin carrier in the spin orbit coupling layer 20 diffuses into the first free layer 41 because the spin-down spin carrier is the same as the magnetization direction of the first free layer 41, and a spin-up spin carrier in the spin orbit coupling layer 20 diffuses into the second free layer 51 because the spin-up spin carrier is the same as the magnetization direction of the second free layer 51. In other words, spin directions of the spin flow of the spin orbit coupling layer 20 may be the same as both the magnetization direction of the first free layer 41 and the magnetization direction of the second free layer 51. In this way, no inverse spin Hall effect is generated. This corresponds to a low current state of the storage component 100, namely, corresponds to a high resistive state of the storage component 100.

Based on this, the storage component 100 provided in this embodiment of this application has three storage states: the low resistive state, the medium resistive state, and the high resistive state. However, for a conventional storage component, when a magnetization direction of a fixed layer is parallel to that of a free layer, the storage component is in a low resistive state, and when a magnetization direction of the fixed layer is antiparallel to that of the free layer, the storage component is in a high resistive state. There are only two storage states. Therefore, according to the storage component 100 provided in this embodiment of this application, a quantity of storage states can be increased, multi-state storage can be implemented, and a storage density of the storage component 100 can be improved.

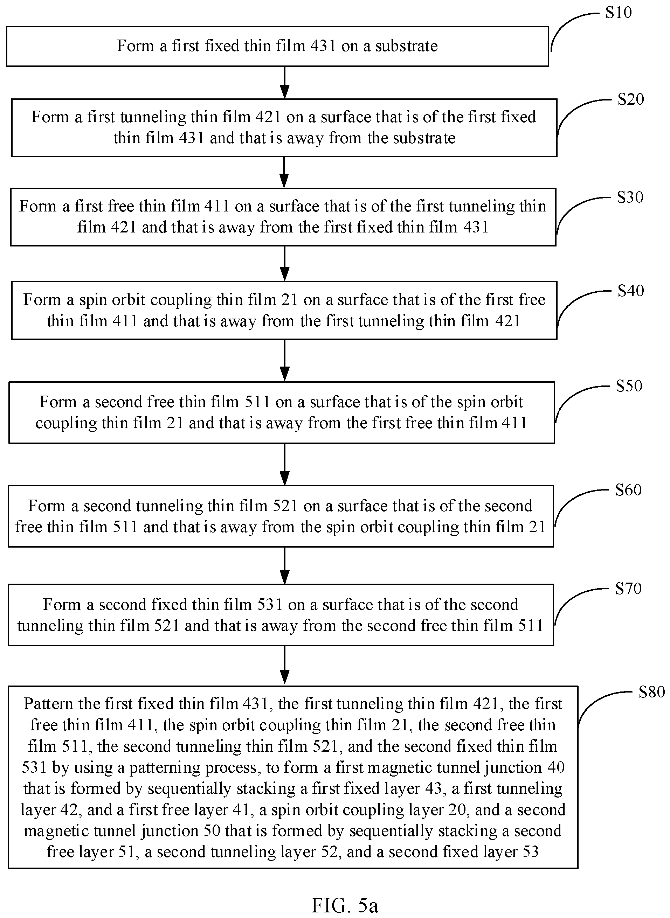

For a method for forming the first magnetic tunnel junction 40, the spin orbit coupling layer 20, and the second magnetic tunnel junction 50 that are sequentially arranged in a stacked manner and that are shown in FIG. 3, in a possible embodiment, as shown in FIG. 5a, a method for preparing a storage component 100 includes the following steps.

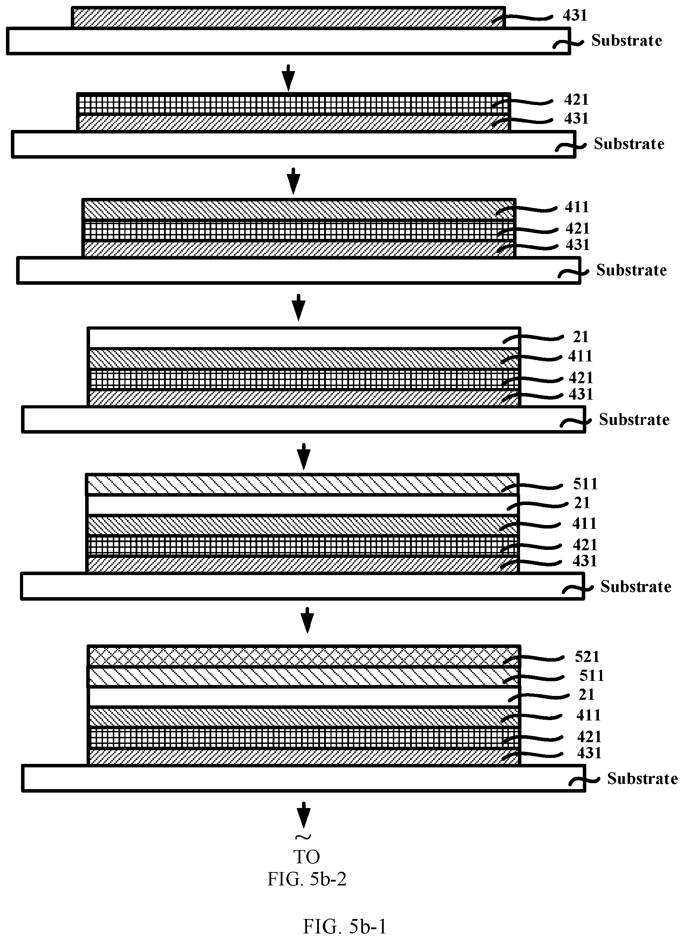

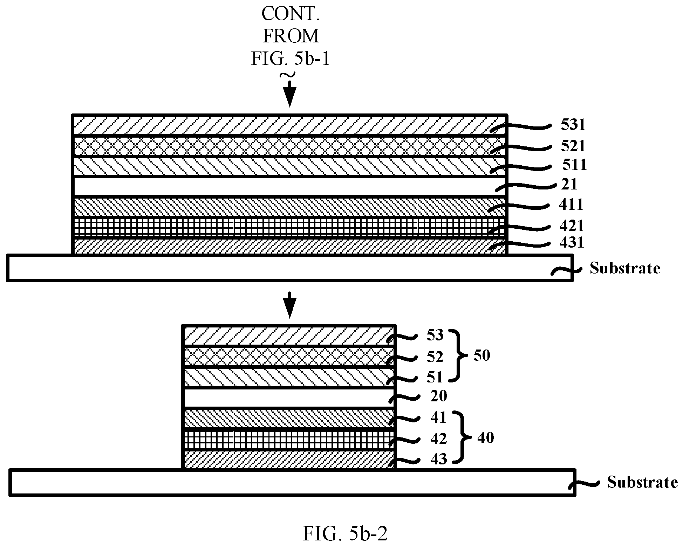

S10: As shown in FIG. 5b-1, form a first fixed thin film 431 on a substrate.

The substrate may be a glass substrate, or may be a Si or SiO2 (silicon oxide) substrate.

For example, the first fixed thin film 431 may be formed by using a magnetron sputtering process, a chemical meteorological deposition process, an electron beam evaporation process, a thermal evaporation process, or the like.

A thickness of the first fixed thin film 431 may be, for example, 2 to 10 nm. A material of the first fixed thin film 431 may be, for example, CoFeB.

S20: As shown inFIG. 5b-1, form a first tunneling thin film 421 on a surface that is of the first fixed thin film 431 and that is away from the substrate.

Similarly, the first tunneling thin film 421 may be formed by using the magnetron sputtering process, the chemical meteorological deposition process, the electron beam evaporation process, the thermal evaporation process, or the like.

A thickness of the first tunneling thin film 421 may be, for example, 0.8 to 5 nm. A material of the first tunneling thin film 421 may be, for example, MgO.

S30: As shown in FIG. 5b-1, form a first free thin film 411 on a surface that is of the first tunneling thin film 421 and that is away from the first fixed thin film 431.

Similarly, the first free thin film 411 may be formed by using the magnetron sputtering process, the chemical meteorological deposition process, the electron beam evaporation process, the thermal evaporation process, or the like.

A thickness of the first free thin film 411 may be, for example, 2 to 10 nm. A material of the first free thin film 411 may be, for example, CoFeB.

S40: As shown inFIG. 5b-1, form a spin orbit coupling thin film 21 on a surface that is of the first free thin film 411 and that is away from the first tunneling thin film 421.

Similarly, the spin orbit coupling thin film 21 may be formed by using the magnetron sputtering process, the chemical meteorological deposition process, the electron beam evaporation process, the thermal evaporation process, or the like.

A thickness of the spin orbit coupling thin film 21 may be, for example, 2 to 20 nm. A material of the spin orbit coupling thin film 21 may be, for example, Ta.

S50: As shown in FIG. 5b-1, form a second free thin film 511 on a surface that is of the spin orbit coupling thin film 21 and that is away from the first free thin film 411.

Similarly, the second free thin film 511 may be formed by using the magnetron sputtering process, the chemical meteorological deposition process, the electron beam evaporation process, the thermal evaporation process, or the like.

A thickness of the second free thin film 511 may be, for example, 2 to 10 nm. A material of the second free thin film 511 may be, for example, CoFeB.

S60: As shown inFIG. 5b-1, form a second tunneling thin film 521 on a surface that is of the second free thin film 511 and that is away from the spin orbit coupling thin film 21.

Similarly, the second tunneling thin film 521 may be formed by using the magnetron sputtering process, the chemical meteorological deposition process, the electron beam evaporation process, the thermal evaporation process, or the like.

A thickness of the second tunneling thin film 521 may be, for example, 0.8 to 5 nm. A material of the second tunneling thin film 521 may be, for example, MgO.

S70: As shown in FIG. 5b-2, form a second fixed thin film 531 on a surface that is of the second tunneling thin film 521 and that is away from the second free thin film 511.

Similarly, the second fixed thin film 531 may be formed by using the magnetron sputtering process, the chemical meteorological deposition process, the electron beam evaporation process, the thermal evaporation process, or the like.

A thickness of the second fixed thin film 531 may be, for example, 2 to 10 nm. A material of the second fixed thin film 531 may be, for example, CoFeB.

S80: As shown in FIG. 5b-2, pattern the first fixed thin film 431, the first tunneling thin film 421, the first free thin film 411, the spin orbit coupling thin film 21, the second free thin film 511, the second tunneling thin film 521, and the second fixed thin film 531 by using a patterning process, to form the first magnetic tunnel junction 40 that is formed by sequentially stacking a first fixed layer 43, a first tunneling layer 42, and a first free layer 41, the spin orbit coupling layer 20, and the second magnetic tunnel junction 50 that is formed by sequentially stacking a second free layer 51, a second tunneling layer 52, and a second fixed layer 53.

The patterning process may be, for example, a composition process (which may include a process such as exposure, image development, and etching). In this embodiment of this application, the first fixed thin film 431, the first tunneling thin film 421, the first free thin film 411, the spin orbit coupling thin film 21, the second free thin film 511, the second tunneling thin film 521, and the second fixed thin film 531 are first formed, and then the foregoing film layers are patterned by using the patterning process, to form the first magnetic tunnel junction 40, the spin orbit coupling layer 20, and the second magnetic tunnel junction 50. The process is mature. No related doping process is required, the process is simple, and preparation efficiency is high.

In addition, the first magnetic tunnel junction 40, the spin orbit coupling layer 20, and the second magnetic tunnel junction 50 that are obtained by means of preparation have equal sizes, so that an area occupied by the storage component 100 can be reduced.

For a method for forming the first magnetic tunnel junction 40, the spin orbit coupling layer 20, and the second magnetic tunnel junction 50 that are sequentially arranged in a stacked manner and that are shown in FIG. 3, in another possible embodiment, as shown in FIG. 6a, a preparation method of a storage component 100 includes the following steps.

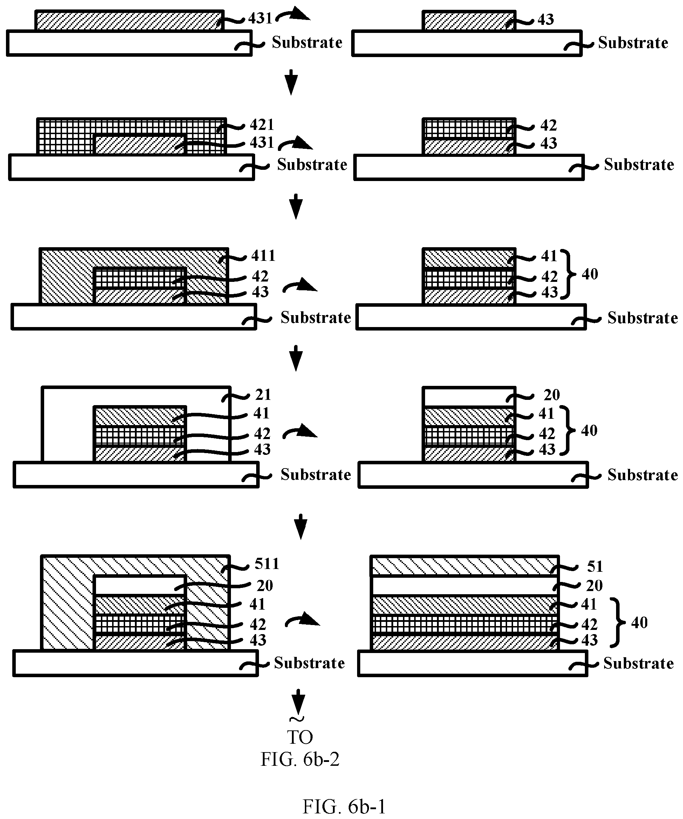

S1: As shown in FIG. 6b, form a first fixed thin film 431 on a substrate, and pattern the first fixed thin film 431 by using a patterning process, to form a first fixed layer 43.

S2: As shown in FIG. 6b, form a first tunneling thin film 421 on a surface that is of the first fixed layer 43 and that is away from the substrate, and pattern the first tunneling thin film 421 by using a patterning process, to form a first tunneling layer 42.

S3: As shown in FIG. 5b, form a first free thin film 411 on a surface that is of the first tunneling layer 42 and that is away from the first fixed layer 43, and pattern the first free thin film 411 by using a patterning process, to form a first free layer 41.

The first fixed layer 43, the first tunneling layer 42, and the first free layer 41 that are arranged in a stacked manner constitute the first magnetic tunnel junction 40.

S4: As shown in FIG. 6b-1, form a spin orbit coupling thin film 21 on a surface that is of the first free layer 41 and that is away from the first tunneling layer 42, and pattern the spin orbit coupling thin film 21 by using a patterning process, to form a spin orbit coupling layer 20.

S5: As shown in FIG. 6b-1, form a second free thin film 511 on a surface that is of the spin orbit coupling layer 20 and that is away from the first free layer 41, and pattern the second free thin film 511 by using a patterning process, to form a second free layer 51.

S6: As shown in FIG. 6b-2, form a second tunneling thin film 521 on a surface that is of the second free layer 51 and that is away from the spin orbit coupling layer 20, and pattern the second tunneling thin film 521 by using a patterning process, to form a second tunneling layer 52.

S7: As shown in FIG. 6b-2, form a second fixed thin film 531 on a surface that is of the second tunneling layer 52 and that is away from the second free layer 51, and pattern the second fixed thin film 531 by using a patterning process, to form a second fixed layer 53.

The second fixed layer 53, the second tunneling layer 52, and the second free layer 51 that are arranged in a stacked manner constitute the second magnetic tunnel junction 50.

For a forming process, a material, and a thickness of each film layer in FIG. 6b-1 and FIG. 6b-2, reference may be made to the foregoing description about FIG. 5b-1 and FIG. 5b-2. Details are not described herein again.

In this embodiment of this application, the foregoing storage component 100 is formed by using a film forming process and the patterning process, and the process is mature. No related doping process is required, the process is simple, and the preparation efficiency is high.

In a possible embodiment, a structure of the first magnetic tunnel junction 40 is the same as that of the second magnetic tunnel junction 50.

It may be understood that, that the structure of the first magnetic tunnel junction 40 is the same as that of the second magnetic tunnel junction 50 means that: The first free layer 41 in the first magnetic tunnel junction 40 and the second free layer 51 in the second magnetic tunnel junction 50 have a same material, thickness, and the like; the first tunneling layer 42 in the first magnetic tunnel junction 40 and the second tunneling layer 52 in the second magnetic tunnel junction 50 have a same material, thickness, and the like; and the first fixed layer 43 in the first magnetic tunnel junction 40 and the second fixed layer 53 in the second magnetic tunnel junction 50 have a same material, thickness, and the like. In other words, a resistance of the first magnetic tunnel junction 40 is equal to that of the second magnetic tunnel junction 50.

In this way, the first magnetic tunnel junction 40 and the second magnetic tunnel junction 50 may be prepared by using a same process, and the preparation process may be simplified.

Based on the structure shown in FIG. 3, in a possible embodiment, as shown in FIG. 7a, the storage component 100 further includes a first electrode 61 and a second electrode 62. The first electrode 61 and the second electrode 62 are coupled to two opposite sides of the spin orbit coupling layer 20.

Materials and structures of the first electrode 61 and the second electrode 62 are not limited, as long as an electrical signal can be transmitted to the spin orbit coupling layer 20.

In a possible embodiment, as shown in FIG. 7a, the storage component 100 further includes a third electrode 63 and a fourth electrode 64. The third electrode 63 is coupled to the first fixed layer 43 of the first magnetic tunnel junction 40, and the fourth electrode 64 is coupled to the second fixed layer 53 of the second magnetic tunnel junction 50.

In a possible embodiment, as shown in FIG. 7b, the second electrode 62, the third electrode 63, and the fourth electrode 64 are separately coupled to a reference ground end.

The following describes, by using several detailed embodiments, a reading/writing method of the storage component 100 provided in this embodiment of this application.

### Embodiment 1

As shown in FIG. 8, a reading method of a storage component 100 in this embodiment of this application includes the following steps.

S100: Obtain a read instruction of a storage component.

The read instruction refers to a machine instruction obtained by a control circuit that is in a storage chip and that is connected to the storage component 100. For example, the read instruction includes an instruction corresponding to character display, picture display, audio and video playing, application program running, and the like. A manner of obtaining the read instruction includes performing an action, such as a mouse click, a finger tap, or a physical button press, on the corresponding instruction.

S200: Apply a voltage signal to a spin orbit coupling layer 20 according to the read instruction.

In other words, the voltage signal is applied to a first electrode 61 according to the read instruction. After the voltage signal enters the spin orbit coupling layer 20, an in-plane current Iin is formed in the spin orbit coupling layer 20.

S300: Read an output current Iout of the spin orbit coupling layer 20.

After the in-plane current Iin is formed in the spin orbit coupling layer 20, a spin current is generated under an action of a spin Hall effect (SHE). Whether a spin carrier in the spin current generates an inverse spin Hall current Iish due to an inverse spin Hall effect is related to a magnetization direction of a first free layer 41 in a first magnetic tunnel junction 40 and a magnetization direction of a second free layer 51 in a second magnetic tunnel junction 50. In other words, a magnitude of the output current Iout of the spin orbit coupling layer 20 is related to the magnetization direction of the first free layer 41 in the first magnetic tunnel junction 40 and the magnetization direction of the second free layer 51 in the second magnetic tunnel junction 50.

The spin Hall effect refers to the rotation of electrons in different spin directions in a direction perpendicular to a current when no external magnetic field is applied. Therefore, a spin current in a vertical direction is generated.

For example, the output current Iout of the spin orbit coupling layer 20 is read on the first electrode 61 and a second electrode 62 that are located on two sides of the spin orbit coupling layer 20.

S400: Obtain, based on the output current Iout of the spin orbit coupling layer 20, data stored in the first magnetic tunnel junction 40 and the second magnetic tunnel junction 50.

The magnitude of the output current Iout of the spin orbit coupling layer 20 varies with the magnetization direction of the first free layer 41 in the first magnetic tunnel junction 40 and the magnetization direction of the second free layer 51 in the second magnetic tunnel junction 50. Each resistive state has a magnetization direction of the first free layer 41 and a magnetization direction of the second free layer 51 that are corresponding to the resistive state.

Therefore, the magnetization direction of the first free layer 41 and the magnetization direction of the second free layer 51 may be determined by detecting the output current Iout of the spin orbit coupling layer 20, so as to determine which resistive state of a high resistive state, a medium resistive state, and a low resistive state the storage component 100 is in, so that the data stored in the first magnetic tunnel junction 40 and the second magnetic tunnel junction 50 is obtained.

In a possible embodiment, step S400 includes the following steps.

The low resistive state is read when Iout = Iin + Iish.

After the voltage signal enters the spin orbit coupling layer 20, an in-plane current Iin is formed in the spin orbit coupling layer 20. When Iout = Iin + Iish, it indicates that an inverse spin Hall effect is generated in the spin orbit coupling layer 20, and an additional inverse spin Hall current Iish is formed. In other words, as shown in FIG. 9a, spin directions of a spin flow of the spin orbit coupling layer 20 are opposite to both the magnetization direction of the first free layer 41 and the magnetization direction of the second free layer 51. A spin-down spin carrier in the spin orbit coupling layer 20 is bounced back at an interface between the first free layer 41 and the spin orbit coupling layer 20 because a spin direction of the spin-down spin carrier is opposite to the magnetization direction of the first free layer 41. A spin-up spin carrier in the spin orbit coupling layer 20 is bounced back at an interface between the second free layer 51 and the spin orbit coupling layer 20 because the spin-up spin carrier is opposite to the magnetization direction of the second free layer 51. In this case, the storage component 100 is in the low resistive state shown in FIG. 4a, so that the low resistive state is read.

The medium resistive state is read when Iout = Iin + 1/2Iish.

After the voltage signal enters the spin orbit coupling layer 20, an in-plane current Iin is formed in the spin orbit coupling layer 20. When Iout = Iin + 1/2Iish, it indicates that an inverse spin Hall effect is generated in the spin orbit coupling layer 20, and a relatively small additional current 1/2Iish is formed. In other words, as shown in FIG. 9b, spin directions of a spin flow of the spin orbit coupling layer 20 are opposite to the magnetization direction of the first free layer 41 and the same as the magnetization direction of the second free layer 51. A spin-down spin carrier in the spin orbit coupling layer 20 is bounced back at an interface between the first free layer 41 and the spin orbit coupling layer 20 because a spin direction of the spin-down spin carrier is opposite to the magnetization direction of the first free layer 41. A spin-up spin carrier in the spin orbit coupling layer 20 diffuses into the second free layer 51 because the spin-up spin carrier is the same as the magnetization direction of the second free layer 51. In this case, the storage component 100 is in the medium resistive state shown in FIG. 4b, so that the medium resistive state is read.

The high resistive state is read when Iout = Iin.

After the voltage signal enters the spin orbit coupling layer 20, an in-plane current Iin is formed in the spin orbit coupling layer 20. When Iout = Iin, it indicates that no inverse spin Hall effect is generated in the spin orbit coupling layer 20, and no inverse spin Hall current Iish is formed. In other words, as shown in FIG. 9c, spin directions of a spin flow of the spin orbit coupling layer 20 are the same as both the magnetization direction of the first free layer 41 and the magnetization direction of the second free layer 51. A spin-down spin carrier in the spin orbit coupling layer 20 diffuses into the first free layer 41 because the spin-down spin carrier is the same as the magnetization direction of the first free layer 41, and a spin-up spin carrier in the spin orbit coupling layer 20 diffuses into the second free layer 51 because the spin-up spin carrier is the same as the magnetization direction of the second free layer 51. In this case, the storage component 100 is in the high resistive state shown in FIG. 4d, so that the high resistive state is read.

For example, the low resistive state may be marked as 0 in a computer machine language, the medium resistive state may be marked as 1 in the computer machine language, and the high resistive state may be marked as 2 in the computer machine language, so as to correspond to ternary "0", "1", and "2" in the computer machine language. The language "0", "1", and "2" corresponding to an output current Iout is read from the storage component 100, and then a read operation of the storage component 100 is completed. Certainly, this is merely an example, and no limitation is imposed herein.

### Embodiment 2

As shown in FIG. 10, a writing method of a storage component 100 in this embodiment of this application includes the following steps.

S1000: Obtain a write instruction of a storage component.

The write instruction refers to a machine instruction obtained by a control circuit connected to the storage component 100. For example, the write instruction includes an instruction corresponding to typing a character, pasting a picture, downloading an application program, and the like. For example, a manner of obtaining the write instruction includes writing the corresponding instruction by using a keyboard, clicking the corresponding instruction by using a mouse, tapping the corresponding instruction by using a finger, or the like. This is not limited in this embodiment.

S2000: Separately apply a voltage signal to a spin orbit coupling layer 20 and at least one of a first magnetic tunnel junction 40 and a second magnetic tunnel junction 50 according to the write instruction, where the voltage signal is used to change resistive states of the first magnetic tunnel junction 40 and the second magnetic tunnel junction 50, so as to write corresponding data into the storage component 100.

In some embodiments, step S2000 includes: Separately apply the voltage signal to the first magnetic tunnel junction 40 and the spin orbit coupling layer 20.

The voltage signal is used to change the resistive state of the first magnetic tunnel junction 40, so as to change a resistive state of the storage component 100, and write, into the storage component 100, data corresponding to the resistive state of the storage component 100.

The voltage signal is applied to the spin orbit coupling layer 20, and an in-plane current Iin is generated in the spin orbit coupling layer 20, so that a spin orbit torque is generated. The voltage signal is applied to a third electrode 63 of the first magnetic tunnel junction 40, and a current flowing from a first fixed layer 43 to a first free layer 41 is formed in the first magnetic tunnel junction 40, so that a spin transfer torque is generated in the first magnetic tunnel junction 40. A magnetization direction of the first free layer 41 is controlled to reverse under a joint action of a spin orbit torque effect and a spin transfer torque effect.

Depending on a requirement, a direction of the spin orbit torque of the spin orbit coupling layer 20 may be adjusted by adjusting a positive voltage signal or a negative voltage signal applied to the spin orbit coupling layer 20. A direction of the spin transfer torque may be adjusted by adjusting a positive voltage signal or a negative voltage signal applied to the third electrode 63. In this way, the magnetization direction of the first free layer 41 is controlled to reverse to facing away from the spin orbit coupling layer 20 or facing toward the spin orbit coupling layer 20. In this way, the resistive state of the first magnetic tunnel junction 40 is changed, so that the resistive state of the storage component 100 is changed, and data corresponding to the resistive state of the storage component 100 is written into the storage component 100.

Optionally, as shown in FIG. 11a, according to the write instruction, a positive voltage signal is applied to the spin orbit coupling layer 20, and a positive voltage signal is applied to the first magnetic tunnel junction 40. In this way, under an action of a spin orbit torque effect of the spin orbit coupling layer 20 and a spin transfer torque effect of the first magnetic tunnel junction 40, the magnetization direction of the first free layer 41 is reversed to facing away from the spin orbit coupling layer 20, the first magnetic tunnel junction 40 changes to be in a high resistive state, the storage component 100 changes to be in a high resistive state from a medium resistive state, and data corresponding to the high resistive state is written into the storage component 100.

When data corresponding to the high resistive state needs to be written, as shown in FIG. 4d, both the magnetization direction of the first free layer 41 and the magnetization direction of the second free layer 51 need to be facing away from the spin orbit coupling layer 20. When a current storage state of the storage component 100 is the medium resistive state, as shown in FIG. 4b, the magnetization direction of the first free layer 41 is facing toward the spin orbit coupling layer 20, and the magnetization direction of the second free layer 51 is facing away from the spin orbit coupling layer 20. Therefore, the magnetization direction of the first free layer 41 needs to be reversed from facing toward the spin orbit coupling layer 20 to facing away from the spin orbit coupling layer 20.

On this basis, as shown in FIG. 11a, the positive voltage signal is applied to the spin orbit coupling layer 20, a positive in-plane current Iin is generated in the spin orbit coupling layer 20, and a spin orbit torque facing away from the spin orbit coupling layer 20 is generated. The positive voltage signal is applied to the first magnetic tunnel junction 40, a positive first spin polarization current I40 is generated in the first magnetic tunnel junction 40, and a spin transfer torque in a direciton antiparallel to the magnetization direction of the first fixed layer 43 is generated. Under a joint action of the spin orbit torque effect and the spin transfer torque effect, the magnetization direction of the first free layer 41 is controlled to reverse to facing away from the spin orbit coupling layer 20. In other words, the magnetization direction of the first free layer 41 is controlled to reverse to be antiparallel to (or understood as opposite to) that of the first fixed layer 43. In this way, the storage state of the storage component 100 is the high resistive state shown in FIG. 4d.

In other words, by applying the positive voltage signal to the spin orbit coupling layer 20 to generate the positive in-plane current Iin, and by applying the positive voltage signal to the first magnetic tunnel junction 40 to generate the positive first spin polarization current I40, the storage component 100 may change to be in the high resistive state from the medium resistive state.

Optionally, as shown in FIG. 11b, according to the write instruction, a negative voltage signal is applied to the spin orbit coupling layer 20, and a negative voltage signal is applied to the first magnetic tunnel junction 40. In this way, under an action of a spin orbit torque effect of the spin orbit coupling layer 20 and a spin transfer torque effect of the first magnetic tunnel junction 40, the magnetization direction of the first free layer 41 is reversed to facing toward the spin orbit coupling layer 20, the first magnetic tunnel junction 40 changes to be in a low resistive state, the storage component 100 changes to be in a medium resistive state from a high resistive state, and data corresponding to the medium resistive state is written into the storage component 100.

When the medium resistive state needs to be written, as shown in FIG. 4b, the magnetization direction of the first free layer 41 needs to be facing toward the spin orbit coupling layer 20, and the magnetization direction of the second free layer 51 needs to be facing away from the spin orbit coupling layer 20. When a current storage state of the storage component 100 is the high resistive state, as shown in FIG. 4d, both the magnetization direction of the first free layer 41 and the magnetization direction of the second free layer 51 are facing away from the spin orbit coupling layer 20. Therefore, the magnetization direction of the first free layer 41 needs to be reversed from facing away from the spin orbit coupling layer 20 to facing toward the spin orbit coupling layer 20.

On this basis, as shown in FIG. 11b, the negative voltage signal is applied to the spin orbit coupling layer 20, a negative in-plane current -Iin is generated in the spin orbit coupling layer 20, and a spin orbit torque facing toward the spin orbit coupling layer 20 is generated. The negative voltage signal is applied to the first magnetic tunnel junction 40, a negative first spin polarization current -I40 is generated in the first magnetic tunnel junction 40, and a spin transfer torque parallel to the magnetization direction of the first fixed layer 43 is generated. Under a joint action of the spin orbit torque effect and the spin transfer torque effect, the magnetization direction of the first free layer 41 is controlled to reverse to facing toward the spin orbit coupling layer 20. In other words, the magnetization direction of the first free layer 41 is controlled to reverse to be parallel to (or understood as the same as) that of the first fixed layer 43. In this way, the storage state of the storage component 100 is the medium resistive state shown in FIG. 4b.

In other words, by applying the negative voltage signal to the spin orbit coupling layer 20 to generate the negative in-plane current -Iin, and by applying the negative voltage signal to the first magnetic tunnel junction 40 to generate the negative first spin polarization current -I40, the storage component 100 may change to be in the medium resistive state from the high resistive state.

In some other embodiments, step S2000 includes: Separately apply the voltage signal to the second magnetic tunnel junction 50 and the spin orbit coupling layer 20.

The voltage signal is used to change the resistive state of the second magnetic tunnel junction 50, so as to change a resistive state of the storage component 100, and data corresponding to the resistive state of the storage component 100 is written into the storage component 100.

The voltage signal is applied to the spin orbit coupling layer 20, and an in-plane current Iin is generated in the spin orbit coupling layer 20, so that a spin orbit torque is generated. The voltage signal is applied to a fourth electrode 64 of the second magnetic tunnel junction 50, and a current flowing from a second fixed layer 53 to a second free layer 51 is formed in the second magnetic tunnel junction 50, so that a spin transfer torque is generated in the second magnetic tunnel junction 50. A magnetization direction of the second free layer 51 is controlled to reverse under a joint action of a spin orbit torque effect and a spin transfer torque effect.

Depending on a requirement, a direction of the spin orbit torque of the spin orbit coupling layer 20 may be adjusted by adjusting a positive voltage signal or a negative voltage signal applied to the spin orbit coupling layer 20. A direction of the spin transfer torque may be adjusted by adjusting a positive voltage signal or a negative voltage signal applied to the fourth electrode 64. In this way, the magnetization direction of the second free layer 51 is controlled to reverse to facing away from the spin orbit coupling layer 20 or facing toward the spin orbit coupling layer 20.

Optionally, as shown in FIG. 12a, according to the write instruction, a negative voltage signal is applied to the spin orbit coupling layer 20, and a positive voltage signal is applied to the second magnetic tunnel junction 50. In this way, under an action of a spin orbit torque effect of the spin orbit coupling layer 20 and a spin transfer torque effect of the second magnetic tunnel junction 50, the magnetization direction of the second free layer 51 is reversed to facing toward the spin orbit coupling layer 20, the second magnetic tunnel junction 50 changes to be in a high resistive state, the storage component 100 changes to be in a low resistive state from a medium resistive state, and data corresponding to the low resistive state is written into the storage component 100.

When the low resistive state needs to be written, as shown in FIG. 4a, both the magnetization direction of the first free layer 41 and the magnetization direction of the second free layer 51 need to be facing toward the spin orbit coupling layer 20. When a current storage state of the storage component 100 is the medium resistive state, as shown in FIG. 4b, the magnetization direction of the first free layer 41 is facing toward the spin orbit coupling layer 20, and the magnetization direction of the second free layer 51 is facing away from the spin orbit coupling layer 20. Therefore, the magnetization direction of the second free layer 51 needs to be reversed from facing away from the spin orbit coupling layer 20 to facing toward the spin orbit coupling layer 20.

On this basis, as shown in FIG. 12a, the negative voltage signal is applied to the spin orbit coupling layer 20, a negative in-plane current -Iin is generated in the spin orbit coupling layer 20, and a spin orbit torque facing toward the spin orbit coupling layer 20 is generated. The positive voltage signal is applied to the second magnetic tunnel junction 50, a positive second spin polarization current I50 is generated in the second magnetic tunnel junction 50, and a spin transfer torque antiparallel to the magnetization direction of the second fixed layer 53 is generated. Under a joint action of the spin orbit torque effect and the spin transfer torque effect, the magnetization direction of the second free layer 51 is controlled to reverse to facing toward the spin orbit coupling layer 20. In other words, the magnetization direction of the second free layer 51 is controlled to reverse to be antiparallel to (or understood as opposite to) that of the second fixed layer 53. Therefore, the storage state of the storage component 100 is the low resistive state shown in FIG. 4a.

In other words, by applying the negative voltage signal to the spin orbit coupling layer 20 to generate the negative in-plane current -Iin, and by applying the positive voltage signal to the second magnetic tunnel junction 50 to generate the positive second spin polarization current I50, the storage component 100 may change to be in the low resistive state from the medium resistive state.

Optionally, as shown in FIG. 12b, according to the write instruction, a positive voltage signal is applied to the spin orbit coupling layer 20, and a negative voltage signal is applied to the second magnetic tunnel junction 50. In this way, under an action of a spin orbit torque effect of the spin orbit coupling layer 20 and a spin transfer torque effect of the second magnetic tunnel junction 50, the magnetization direction of the second free layer 51 is reversed to facing away from the spin orbit coupling layer 20, the second magnetic tunnel junction 50 changes to be in a low resistive state, the storage component 100 changes to be in a medium resistive state from a low resistive state, and data corresponding to the medium resistive state is written into the storage component 100.

When the medium resistive state needs to be written, as shown in FIG. 4b, the magnetization direction of the first free layer 41 needs to be facing toward the spin orbit coupling layer 20, and the magnetization direction of the second free layer 51 needs to be facing away from the spin orbit coupling layer 20. When a current storage stateof the storage component 100 is the low resistive state, as shown in FIG. 4a, both the magnetization direction of the first free layer 41 and the magnetization direction of the second free layer 51 are facing toward the spin orbit coupling layer 20. Therefore, the magnetization direction of the second free layer 51 needs to be reversed from facing toward the spin orbit coupling layer 20 to facing away from the spin orbit coupling layer 20.

On this basis, as shown in FIG. 12b, the positive voltage signal is applied to the spin orbit coupling layer 20, a positive in-plane current Iin is generated in the spin orbit coupling layer 20, and a spin orbit torque facing away from the spin orbit coupling layer 20 is generated. The negative voltage signal is applied to the second magnetic tunnel junction 50, a negative second spin polarization current -I50 is generated in the second magnetic tunnel junction 50, and a spin transfer torque parallel to the magnetization direction of the second fixed layer 53 is generated. Under a joint action of the spin orbit torque effect and the spin transfer torque effect, the magnetization direction of the second free layer 51 is controlled to reverse to facing away from the spin orbit coupling layer 20. In other words, the magnetization direction of the second free layer 51 is controlled to reverse to be parallel to (or understood as the same as) that of the second fixed layer 53. In this way, the storage state of the storage component 100 is the medium resistive state shown in FIG. 4b.

In other words, by applying the positive voltage signal to the spin orbit coupling layer 20 to generate the positive in-plane current Iin, and by applying the negative voltage signal to the second magnetic tunnel junction 50 to generate the negative second spin polarization current -I50, the storage component 100 may change to be in the medium resistive state from the low resistive state.

In some other embodiments, step S2000 includes: Separately apply the voltage signal to the first magnetic tunnel junction 40, the second magnetic tunnel junction 50, and the spin orbit coupling layer 20. The voltage signal is used to change resistive states of the first magnetic tunnel junction 40 and the second magnetic tunnel junction 50, so as to change a resistive state of the storage component 100, and write, into the storage component 100, data corresponding to the resistive state of the storage component 100 is written.

The voltage signal is applied to the spin orbit coupling layer 20, and an in-plane current Iin is generated in the spin orbit coupling layer 20, so that a spin orbit torque is generated. The voltage signal is applied to a third electrode 63 of the first magnetic tunnel junction 40, and a current flowing from a first fixed layer 43 to a first free layer 41 is formed in the first magnetic tunnel junction 40, so that a spin transfer torque is generated in the first magnetic tunnel junction 40. A magnetization direction of the first free layer 41 is controlled to reverse under a joint action of a spin orbit torque effect and a spin transfer torque effect.

Depending on a requirement, a direction of the spin orbit torque of the spin orbit coupling layer 20 may be adjusted by adjusting a positive voltage signal or a negative voltage signal applied to the spin orbit coupling layer 20. A direction of the spin transfer torque may be adjusted by adjusting a positive voltage signal or a negative voltage signal applied to the third electrode 63. In this way, the magnetization direction of the first free layer 41 is controlled to reverse to facing away from the spin orbit coupling layer 20 or facing toward the spin orbit coupling layer 20.

In addition, the voltage signal is applied to a fourth electrode 64 of the second magnetic tunnel junction 50, and a current flowing from a second fixed layer 53 to a second free layer 51 is formed in the second magnetic tunnel junction 50, so that a spin transfer torque is generated in the second magnetic tunnel junction 50. A magnetization direction of the second free layer 51 is controlled to reverse under a joint action of the spin orbit torque effect and the spin transfer torque effect.

Depending on a requirement, a direction of the spin orbit torque of the spin orbit coupling layer 20 may be adjusted by adjusting a positive voltage signal or a negative voltage signal applied to the spin orbit coupling layer 20. A direction of the spin transfer torque may be adjusted by adjusting a positive voltage signal or a negative voltage signal applied to the fourth electrode 64. In this way, the magnetization direction of the second free layer 51 is controlled to reverse to facing away from the spin orbit coupling layer 20 or facing toward the spin orbit coupling layer 20.

Optionally, as shown in FIG. 13a, according to the write instruction, a positive voltage signal is applied to the spin orbit coupling layer 20, a positive voltage signal is applied to the first magnetic tunnel junction 40, and a negative voltage signal is applied to the second magnetic tunnel junction 50. In this way, under an action of a spin orbit torque effect of the spin orbit coupling layer 20 and a spin transfer torque effect of the first magnetic tunnel junction 40, the magnetization direction of the first free layer 41 is reversed to facing away from the spin orbit coupling layer 20, and the first magnetic tunnel junction 40 changes to be in a high resistive state. Under an action of the spin orbit torque effect of the spin orbit coupling layer 20 and a spin transfer torque effect of the second magnetic tunnel junction 50, the magnetization direction of the second free layer 51 is reversed to facing away from the spin orbit coupling layer 20, the second magnetic tunnel junction 50 changes to be in a low resistive state, the storage component 100 changes to be in a high resistive state from a low resistive state, and data corresponding to the high resistive state is written into the storage component 100.

When the high resistive state needs to be written, as shown in FIG. 4d, both the magnetization direction of the first free layer 41 and the magnetization direction of the second free layer 51 need to be facing away from the spin orbit coupling layer 20. When a current storage state of the storage component 100 is the low resistive state, as shown in FIG. 4a, both the magnetization direction of the first free layer 41 and the magnetization direction of the second free layer 51 are facing toward the spin orbit coupling layer 20. Therefore, the magnetization direction of the first free layer 41 needs to be reversed from facing toward the spin orbit coupling layer 20 to facing away from the spin orbit coupling layer 20, and the magnetization direction of the second free layer 51 needs to be reversed from facing toward the spin orbit coupling layer 20 to facing away from the spin orbit coupling layer 20.

On this basis, as shown in FIG. 13a, the positive voltage signal is applied to the spin orbit coupling layer 20, a positive in-plane current Iin is generated in the spin orbit coupling layer 20, and a spin orbit torque facing away from the spin orbit coupling layer 20 is generated. The positive voltage signal is applied to the first magnetic tunnel junction 40, a positive first spin polarization current I40 is generated in the first magnetic tunnel junction 40, and a spin transfer torque antiparallel to the magnetization direction of the first fixed layer 43 is generated. Under a joint action of the spin orbit torque effect and the spin transfer torque effect, the magnetization direction of the first free layer 41 is controlled to reverse to facing away from the spin orbit coupling layer 20. In other words, the magnetization direction of the first free layer 41 is controlled to reverse to be antiparallel to (or understood as opposite to) that of the first fixed layer 43.

In addition, the negative voltage signal is applied to the second magnetic tunnel junction 50, a negative second spin polarization current -I50 is generated in the second magnetic tunnel junction 50, and a spin transfer torque parallel to the magnetization direction of the second fixed layer 53 is generated. Under a joint action of the spin orbit torque effect and the spin transfer torque effect, the magnetization direction of the second free layer 51 is controlled to reverse to facing away from the spin orbit coupling layer 20. In other words, the magnetization direction of the second free layer 51 is controlled to reverse to be parallel to (or understood as the same as) the second fixed layer 53. In this way, the storage state of the storage component 10 is the high resistive state shown in FIG. 4d.

In other words, by applying the positive voltage signal to the spin orbit coupling layer 20 to generate the positive in-plane current Iin, by applying the positive voltage signal to the first magnetic tunnel junction 40 to generate the positive first spin polarization current I40, and by applying the negative voltage signal to the second magnetic tunnel junction 50 to generate the negative second spin polarization current -I50, the storage component 100 may change to be in the high resistive state from the low resistive state.

Optionally, as shown in FIG. 13b, according to the write instruction, a negative voltage signal is applied to the spin orbit coupling layer 20, a negative voltage signal is applied to the first magnetic tunnel junction 40, and a positive voltage signal is applied to the second magnetic tunnel junction 50. In this way, under an action of a spin orbit torque effect of the spin orbit coupling layer 20 and a spin transfer torque effect of the first magnetic tunnel junction 40, the magnetization direction of the first free layer 41 is reversed to facing toward the spin orbit coupling layer 20, and the first magnetic tunnel junction 40 changes to be in a low resistive state. Under an action of the spin orbit torque effect of the spin orbit coupling layer 20 and a spin transfer torque effect of the second magnetic tunnel junction 50, the magnetization direction of the second free layer 51 is reversed to facing toward the spin orbit coupling layer 20, the second magnetic tunnel junction 50 changes to be in a high resistive state, the storage component 100 changes to be in a low resistive state from a high resistive state, and data corresponding to the low resistive state is written into the storage component 100.

When the low resistive state needs to be written, as shown in FIG. 4a, both the magnetization direction of the first free layer 41 and the magnetization direction of the second free layer 51 need to be facing toward the spin orbit coupling layer 20. When a current storage state of the storage component 100 is the high resistive state, as shown in FIG. 4d, both the magnetization direction of the first free layer 41 and the magnetization direction of the second free layer 51 are facing away from the spin orbit coupling layer 20. Therefore, the magnetization direction of the first free layer 41 needs to be reversed from facing away from the spin orbit coupling layer 20 to facing toward the spin orbit coupling layer 20, and the magnetization direction of the second free layer 51 needs to be reversed from facing away from the spin orbit coupling layer 20 to facing toward the spin orbit coupling layer 20.

Based on this, as shown in FIG. 13b, the negative voltage signal is applied to the spin orbit coupling layer 20, a negative in-plane current -Iin is generated in the spin orbit coupling layer 20, and a spin orbit torque facing toward the spin orbit coupling layer 20 is generated. The negative voltage signal is applied to the first magnetic tunnel junction 40, a negative first spin polarization current -I40 is generated in the first magnetic tunnel junction 40, and a spin transfer torque parallel to the magnetization direction of the first fixed layer 43 is generated. Under a joint action of the spin orbit torque effect and the spin transfer torque effect, the magnetization direction of the first free layer 41 is controlled to reverse to facing toward the spin orbit coupling layer 20. In other words, the magnetization direction of the first free layer 41 is controlled to reverse to be parallel to (or understood as the same as) the first fixed layer 43.

In addition, the positive voltage signal is applied to the second magnetic tunnel junction 50, a positive second spin polarization current I50 is generated in the second magnetic tunnel junction 50, and a spin transfer torque antiparallel to the magnetization direction of the second fixed layer 53 is generated. Under a joint action of the spin orbit torque effect and the spin transfer torque effect, the magnetization direction of the second free layer 51 is controlled to reverse to facing toward the spin orbit coupling layer 20. In other words, the magnetization direction of the second free layer 51 is controlled to reverse to be antiparallel to (or understood as opposite to) the second fixed layer 53. Therefore, the storage state of the storage component 100 is the low resistive state shown in FIG. 4a.

In other words, by applying the negative voltage signal to the spin orbit coupling layer 20 to generate the negative in-plane current -Iin, by applying the negative voltage signal to the first magnetic tunnel junction 40 to generate the negative first spin polarization current -I40, and by applying the positive voltage signal to the second magnetic tunnel junction 50 to generate the positive second spin polarization current I50, the storage component 100 may change to be in the low resistive state from the high resistive state.

In other words, a writing principle of the storage component 100 provided in this embodiment of this application is as follows: When the magnetization direction of the first free layer 41 or the magnetization direction of the second free layer 51 needs to be reversed to facing away from the spin orbit coupling layer 20, a positive voltage signal is applied to the spin orbit coupling layer 20. Similarly, when the magnetization direction of the free layer 41 or the magnetization direction of the second free layer 51 needs to be reversed to facing toward the spin orbit coupling layer 20, a negative voltage signal is applied to the spin orbit coupling layer 20.

In addition, when the magnetization direction of the first free layer 41 needs to be reversed to facing away from the spin orbit coupling layer 20, a positive voltage signal is applied to the third electrode 63 of the first magnetic tunnel junction 40. Similarly, when the magnetization direction of the first free layer 41 needs to be reversed to facing toward the spin orbit coupling layer 20, a negative voltage signal is applied to the third electrode 63 of the first magnetic tunnel junction 40.

When the magnetization direction of the second free layer 51 needs to be reversed to facing away from the spin orbit coupling layer 20, a negative voltage signal is applied to the fourth electrode 64 of the second magnetic tunnel junction 50. Similarly, when the magnetization direction of the second free layer 51 needs to be reversed to facing toward the spin orbit coupling layer 20, a positive voltage signal is applied to the fourth electrode 64 of the second magnetic tunnel junction 50.

It should be noted that, when the writing method of the storage component 100 provided in this embodiment of this application is described above, only an example in which when the storage component 100 is in the medium resistive state, the magnetization directions of the first free layer 41 and the second free layer 51 are shown in FIG. 4b is used. If the magnetization directions of the first free layer 41 and the second free layer 51 are shown in FIG. 4c when the storage component 100 is in the medium resistive state, the foregoing principle is used to control the magnetization directions of the first free layer 41 and the second free layer 51 to be reversed correspondingly.

For example, according to the write instruction, a negative voltage signal is applied to the spin orbit coupling layer 20, and a negative voltage signal is applied to the first magnetic tunnel junction 40. In this way, under an action of a spin orbit torque effect of the spin orbit coupling layer 20 and a spin transfer torque effect of the first magnetic tunnel junction 40, the magnetization direction of the first free layer 41 is reversed to facing toward the spin orbit coupling layer 20, the first magnetic tunnel junction 40 changes to be in a low resistive state, the storage component 100 changes to be in a low resistive state from a medium resistive state, and data corresponding to the low resistive state is written into the storage component 100.

According to the write instruction, a positive voltage signal is applied to the spin orbit coupling layer 20, and a positive voltage signal is applied to the first magnetic tunnel junction 40. In this way, under an action of a spin orbit torque effect of the spin orbit coupling layer 20 and a spin transfer torque effect of the first magnetic tunnel junction 40, the magnetization direction of the first free layer 41 is reversed to facing away from the spin orbit coupling layer 20, the first magnetic tunnel junction 40 changes to be in a high resistive state, the storage component 100 changes to be in a medium resistive state from a low resistive state, and data corresponding to the medium resistive state is written into the storage component 100.

According to the write instruction, a positive voltage signal is applied to the spin orbit coupling layer 20, and a negative voltage signal is applied to the second magnetic tunnel junction 50. In this way, under an action of a spin orbit torque effect of the spin orbit coupling layer 20 and a spin transfer torque effect of the second magnetic tunnel junction 50, the magnetization direction of the second free layer 51 is reversed to facing away from the spin orbit coupling layer 20, the second magnetic tunnel junction 50 changes to be in a low resistive state, the storage component 100 changes to be in a high resistive state from a medium resistive state, and data corresponding to the high resistive state is written into the storage component 100.

According to the write instruction, a negative voltage signal is applied to the spin orbit coupling layer 20, and a positive voltage signal is applied to the second magnetic tunnel junction 50. In this way, under an action of a spin orbit torque effect of the spin orbit coupling layer 20 and a spin transfer torque effect of the second magnetic tunnel junction 50, the magnetization direction of the second free layer 51 is reversed to facing toward the spin orbit coupling layer 20, the second magnetic tunnel junction 50 changes to be in a high resistive state, the storage component 100 changes to be in a medium resistive state from a high resistive state, and data corresponding to the medium resistive state is written into the storage component 100.

Data writing when the storage component changes to be in the high resistive state from the low resistive state and data writing when the storage component changes to be in the low resistive state from the high resistive state are the same as the descriptions above.

For example, the low resistive state may be marked as 0 in a computer machine language, the medium resistive state may be marked as 1 in the computer machine language, and the high resistive state may be marked as 2 in the computer machine language, so as to correspond to ternary "0", "1", and "2" in the computer machine language. The language "0", "1", and "2" corresponding to a resistive state is stored in the storage component 100, and then a write operation of the storage component 100 is completed. Certainly, this is merely an example, and no limitation is imposed herein.

According to the storage component 100 provided in this embodiment of this application, the first magnetic tunnel junction 40 has two resistive states: a low resistive state and a high resistive state, and the second magnetic tunnel junction 50 also has two resistive states: a low resistive state and a high resistive state. Therefore, after mixed combination, the storage component 100 has three states: a low resistive state, a medium resistive state, and a high resistive state. Compared with a conventional storage component in which a low resistive state and a high resistive state are formed based on parallelism or antiparallelism between a free layer and a fixed layer, the storage component 100 provided in this embodiment of this application can implement multi-state storage.

In addition, because the first magnetic tunnel junction 40 and the second magnetic tunnel junction 50 are respectively arranged on two sides of the spin orbit coupling layer 20 in the storage component 100, which are equivalent to two resistors disposed in parallel, a maximum resistance is doubled, so that a maximum resistance of the storage component 100 is increased, and a corresponding interval from the low resistive state to the high resistive state is also relatively large, so that a resistive state value range is enlarged. When the resistive state value range is enlarged, a difference between the resistive states may be increased, so that a degree of differentiation among the resistive states is increased, and read/write accuracy of multi-state storage can be improved. For example, a resistive state value range is 1000 ohms to 2500 ohms in a related technology. The resistive state value range may be divided for the three resistive states in a manner in which 1000 ohms, 1750 ohms and 2500 ohms each correspond to one resistive state, where a difference between adjacent resistive states is 750 ohms. If a resistive state value range is 1000 ohms to 5000 ohms, the resistive state value range may be divided for the three resistive states in a manner in which 1000 ohms, 3000 ohms and 5000 ohms each correspond to one resistive state, where a difference between adjacent resistive states is 2000 ohms, so that the degree of differentiation among the resistive states is obviously increased.

In addition, in the storage component 100 provided in this embodiment of this application, mutual conversion among the resistive states is completed under a joint action of a spin orbit torque effect and a spin transfer torque effect, so as to complete data writing with high working efficiency.

### Embodiment 3

As shown in FIG. 14, a reading method of a storage component 100 in this embodiment of this application includes the following steps.

S 10000: Obtain a read instruction of a storage component.

S20000: Apply a voltage signal to a spin orbit coupling layer 20 according to the read instruction.

In other words, the voltage signal is applied to a first electrode 61 according to the read instruction. After the voltage signal enters the spin orbit coupling layer 20, an in-plane current Iin is formed in the spin orbit coupling layer 20. A spin-down spin carrier in the in-plane current Iin flows to a third electrode 63 after passing through a first magnetic tunnel junction 40, and a spin-up spin carrier flows to a fourth electrode 64 after passing through a second magnetic tunnel junction 50.

A principle of a magnetic tunnel junction is as follows: The magnetic tunnel junction includes three layers: a magnetic layer (fixed layer), a non-ferromagnetic layer (tunneling layer), and a magnetic layer (free layer). The fixed layer has a large coercive force, and a magnetization direction of the fixed layer is not easily reversed. The free layer has a small coercive force, and the magnetization direction of the fixed layer is easily reversed. When a magnetization direction of the free layer is parallel to that of the fixed layer, a resistance of the entire magnetic tunnel junction is relatively small. When the magnetization direction of the free layer is antiparallel to that of the fixed layer, a resistance of the entire magnetic tunnel junction is relatively large.

Based on this, when a magnetization direction of a first free layer 41 in the first magnetic tunnel junction 40 is parallel to that of a first fixed layer 43, the first magnetic tunnel junction 40 is in a low resistive state, where R40=R40↑↑. When the magnetization direction of the first free layer 41 in the first magnetic tunnel junction 40 is antiparallel to that of the first fixed layer 43, the first magnetic tunnel junction 40 is in a high resistive state, where R40=R40↑↓. R40↑↑<R40↑↓.

Similarly, when a magnetization direction of a second free layer 51 in the second magnetic tunnel junction 50 is parallel to that of a second fixed layer 53, the second magnetic tunnel junction 50 is in a low resistive state, where R50=R50↑↑. When the magnetization direction of the second free layer 51 in the second magnetic tunnel junction 50 is antiparallel to that of the second fixed layer 53, the second magnetic tunnel junction 50 is in a high resistive state, where R50=R50↑↓. R50↑↑<R50↑↓.

In this case, the storage component 100 may be simplified to a structure shown in FIG. 15. A structure of the storage component 100 in the upper figure of FIG. 15 may be simplified to a circuit structure in the lower figure of FIG. 15.

S30000: Read an output current I40' of the first magnetic tunnel junction 40 and an output current I50' of the second magnetic tunnel junction 50.

S40000: Obtain, based on the output current I40' of the first magnetic tunnel junction 40 and the output current I50' of the second magnetic tunnel junction 50, data stored in the first magnetic tunnel junction 40 and the second magnetic tunnel junction 50. For example, a resistive state of the storage component 100 corresponding to a difference Iout' between the output current I40' of the first magnetic tunnel junction 40 and the output current I50' of the second magnetic tunnel junction 50 is obtained according to the difference Iout' between the output current I40' of the first magnetic tunnel junction 40 and the output current I50' of the second magnetic tunnel junction 50. One Iout' corresponds to one resistive state, and resistive states may be distinguished based on Iout', so as to read a corresponding resistive state.

For example, as shown in FIG. 16, Iout' = I40' - I50' = V/R40↑↑ - V/R50↑↑ = A. When it is detected that an output current Iout' of a differential amplifier 70 is A, it can be learned that the first magnetic tunnel junction 40 is in a low resistive state, and the magnetization direction of the first free layer 41 in the first magnetic tunnel junction 40 is parallel to that of the first fixed layer 43. The second magnetic tunnel junction is also in a low resistive state, and the magnetization direction of the second free layer 51 in the second magnetic tunnel junction 50 is parallel to that of the second fixed layer 53. It indicates that a state of the storage component 100 is the medium resistive state shown in FIG. 4b, and the medium resistive state is read.

Similarly, as shown in FIG. 17, Iout' = V/R40↑↓ - V/R50↑↓ = B. When it is detected that an output current Iout' of the differential amplifier 70 is B, it can be learned that the first magnetic tunnel junction 40 is in a high resistive state, and the magnetization direction of the first free layer 41 in the first magnetic tunnel junction 40 is antiparallel to that of the first fixed layer 43. The second magnetic tunnel junction is also in a high resistive state, and the magnetization direction of the second free layer 51 in the second magnetic tunnel junction 50 is antiparallel to that of the second fixed layer 53. It indicates that a state of the storage component 100 is the medium resistive state shown in FIG. 4c, and the medium resistive state is read.

Similarly, as shown in FIG. 18, Iout' = V/R40↑↓ - V/R50↑↑ = C. When it is detected that an output current Iout' of the differential amplifier 70 is C, it can be learned that the first magnetic tunnel junction 40 is in a high resistive state, and the magnetization direction of the first free layer 41 in the first magnetic tunnel junction 40 is antiparallel to that of the first fixed layer 43. The second magnetic tunnel junction is in a low resistive state, and the magnetization direction of the second free layer 51 in the second magnetic tunnel junction 50 is parallel to that of the second fixed layer 53. It indicates that a state of the storage component 100 is the high resistive state shown in FIG. 4d, and the high resistive state is read.

Similarly, as shown in FIG. 19, Iout' = V/R40↑↑ - V/R50↑↓ = D. When it is detected that an output current Iout' of the differential amplifier 70 is D, it can be learned that the first magnetic tunnel junction 40 is in a low resistive state, and the magnetization direction of the first free layer 41 in the first magnetic tunnel junction 40 is parallel to that of the first fixed layer 43. The second magnetic tunnel junction is in a high resistive state, and the magnetization direction of the second free layer 51 in the second magnetic tunnel junction 50 is antiparallel to that of the second fixed layer 53. It indicates that a state of the storage component 100 is the low resistive state shown in FIG. 4a, and the low resistive state is read.

When the first magnetic tunnel junction 40 and the second magnetic tunnel junction 50 are of a same structure, a resistance of the first magnetic tunnel junction 40 in the low resistive state is equal to that of the second magnetic tunnel junction 50 in the low resistive state. In other words, R40↑↑ = R50↑↑. In this case, V/R40↑↑ = V/R50↑↑. A resistance of the first magnetic tunnel junction 40 in the high resistive state is equal to that of the second magnetic tunnel junction 50 in the high resistive state. In other words, R40↑↓ = R50↑↓. In this case, V/R40↑↓ = V/R50↑. In this case, A = B = 0. Because V/R40↑↓ < V/R50↑↑, C < 0. Because V/R40↑↑ > V/R50↑↓, D > 0.

Based on this, in some embodiments, when Iout' = 0, the medium resistive state is read.

When Iout' = 0, Iout' = I40' - I50' = V/R40 - V/R50 = 0, which indicates that V/R40 = V/R50. In this case, as shown in FIG. 16 and FIG. 17, the state of the memory 100 is the medium resistive state shown in FIG. 4b and FIG. 4c, and the medium resistive state is read.

It may be understood that, affected by factors such as a process error and an applicable environment, the output current Iout' of the differential amplifier 70 may be approximately equal to 0. In other words, the output current Iout' of the differential amplifier 70 is 0 ± ε. ε is an error, which can be set depending on an experiment.

The high resistive state is read when Iout' < 0.

When Iout' < 0, Iout' = I40' - I50' = V/R40 - V/R50 < 0, which indicates that V/R40 is less than V/R50. In this case, as shown in FIG. 18, the state of the memory is the high resistive state shown in FIG. 4d, and the high resistive state is read.

The low resistive state is read when Iout' > 0.

When Iout' > 0, Iout' = I40' - I50' = V/R40 - V/R50 > 0, which indicates that V/R40 is greater than V/R50. In this case, as shown in FIG. 19, the state of the storage component 100 is the low resistive state shown in FIG. 4a, and the low resistive state is read.

In this way, only the three types of output currents Iout' need to be determined and processed, so that a data processing amount can be reduced.

Based on this, in some embodiments, as shown in FIG. 20, a peripheral circuit coupled to the storage component 100 includes a differential amplifier 70.

A first input end i1 of the differential amplifier 70 is coupled to a third electrode 63, and a second input end i2 of the differential amplifier 70 is coupled to a fourth electrode 64. A first input end i1 of one differential amplifier 70 is coupled to one third electrode 63, and a second input end i2 of one differential amplifier 70 is coupled to one fourth electrode 64.

It should be noted that FIG. 20 is illustrated by using an example in which the first input end i1 of the differential amplifier 70 is a positive input end and the second input end i2 of the differential amplifier 70 is a negative input end. Certainly, the first input end i1 of the differential amplifier 70 may also be a negative input end, and the second input end i2 of the differential amplifier 70 may also be a positive input end, provided that the first input end i1 and the second input end i2 are positive and negative input ends of each other.

If the first input end i1 of the differential amplifier 70 is a positive input end, and the second input end i2 of the differential amplifier 70 is a negative input end, a result output by an output end o of the differential amplifier 70 is a difference between an output current I40' of a first magnetic tunnel junction 40 and an output current I50' of a second magnetic tunnel junction 50. If the first input end i1 of the differential amplifier 70 is a negative input end, and the second input end i2 of the differential amplifier 70 is a positive input end, a result output by the output end o of the differential amplifier 70 is an opposite number of the difference between the output current I40' of the first magnetic tunnel junction 40 and the output current I50' of the second magnetic tunnel junction 50.

For ease of description, in this embodiment of this application, an example in which the first input end i1 of the differential amplifier 70 is a positive input end and the second input end i2 of the differential amplifier 70 is a negative input end is used for description.

A first current I40' received by the first input end i1 of the differential amplifier 70 is V/R40, and a second current I50' received by the second input end i2 of the differential amplifier 70 is V/R50. V is a voltage applied to a spin orbit coupling layer 20.

After performing differential reading on a current (the output current I40' of the first magnetic tunnel junction 40) input at the first input end i1 and a current (the output current I50' of the second magnetic tunnel junction 50) input at the second input end i2, the differential amplifier 70 outputs a current from the output end o. The output current of the differential amplifier 70 is equal to a difference between the output current I40' of the first magnetic tunnel junction 40 and the output current I50' of the second magnetic tunnel junction 50, namely, Iout" = Iout' = I40' - I50'. In other words, the differential amplifier 70 is used for obtaining a difference Iout' between the output current I40' of the first magnetic tunnel junction 40 and the output current I50' of the second magnetic tunnel junction 50.

The differential amplifier 70 is used for amplifying the difference Iout' between the output current I40' of the first magnetic tunnel junction 40 and the output current I50' of the second magnetic tunnel junction 50 by a fixed gain, and then outputting an amplified value, so that output currents Iout' in different resistive states have a higher degree of differentiation, thereby obtaining a resistive state corresponding to a read instruction more accurately, and reading data with higher accuracy.

In some other embodiments, as shown in FIG. 21, a first input end i1 of a differential amplifier 70 is coupled to a third electrode 63, and a second input end i2 of the differential amplifier 70 is coupled to a fourth electrode 64. A first input end i1 of one differential amplifier 70 is coupled to multiple third electrodes 63, and a second input end i2 of one differential amplifier 70 is coupled to multiple fourth electrodes 64.

In this case, a peripheral circuit coupled to the storage component 100 further includes a time-sharing read control circuit 80. The time-sharing read control circuit 80 is coupled to the storage component 100, and is configured to send a time-sharing read instruction to the storage component 100, so that the multiple third electrodes 63 transmit signals to the first input end i1 of the differential amplifier 70 in a time-sharing manner, and the multiple fourth electrodes 64 transmit signals to the second input end i2 of the differential amplifier 70 in a time-sharing manner.

A process in which the differential amplifier 70 processes a current (an output current I40' of the first magnetic tunnel junction 40) input by the first input end i1 and a current (an output current I50' of the second magnetic tunnel junction 50) input by the second input end i2 is the same as that described in FIG. 20. A difference only lies in that: According to an instruction of the time-sharing read control circuit 80, in the storage component 100, only one of the multiple third electrodes 63 transmits a signal to the first input end i1 of the differential amplifier 70 at a same moment, and the multiple fourth electrodes 64 transmit signals to the second input end i2 of the differential amplifier 70 in a time-sharing manner.

It may be understood that, the third electrode 63 and the fourth electrode 64 that transmit signals to the first input end i1 and the second input end i2 of the differential amplifier 70 at a same moment are located on two sides of a same spin orbit coupling layer 20.

According to the storage component 100 provided in this embodiment of this application, a quantity of differential amplifiers 70 can be decreased, so that an area of the storage component 100 is reduced.

An embodiment of this application further provides a computer-readable storage medium. The computer-readable storage medium stores computer instructions. When the computer instructions are run on an electronic device, the electronic device is enabled to perform the foregoing related method steps, to implement the reading method or the writing method in the foregoing embodiment.

An embodiment of this application further provides a computer program product. When the computer program product is run on a computer, the computer is enabled to perform the foregoing related steps, to implement the reading method or the writing method performed by the electronic device in the foregoing embodiment.

It should be noted above that high, medium, and low mentioned in embodiments of this application are relative based on a result value, and are not specifically limited.

The foregoing description is merely a specific implementation of this application, but is not intended to limit the protection scope of this application The protection scope of this application is subject to the protection scope of the claims.

## Claims

1. A storage chip comprising a storage component, which comprises a first magnetic tunnel junction (40), a spin orbit coupling layer (20), and a second magnetic tunnel junction (50) that are sequentially arranged in a stacked manner, wherein
the first magnetic tunnel junction (40) comprises a first free layer (41), and the second magnetic tunnel junction (50) comprises a second free layer (51); and
the first free layer (41) and the second free layer (51) are arranged on two opposite surfaces of the spin orbit coupling layer (20),
wherein the first magnetic tunnel junction (40) further comprises a first tunneling layer (42) and a first fixed layer (43) that are sequentially arranged on the first free layer (41) in a stacked manner; and/or the second magnetic tunnel junction (50) further comprises a second tunneling layer (52) and a second fixed layer (53) that are sequentially arranged on the second free layer (51) in a stacked manner,
wherein the storage component further comprises a first electrode (61) and a second electrode (62); and the first electrode (61) and the second electrode (62) are coupled to two opposite sides of the spin orbit coupling layer (20),
wherein the storage component further comprises a third electrode (63) and a fourth electrode (64); and the third electrode (63) is coupled to the first fixed layer (43) of the first magnetic tunnel junction (40), and the fourth electrode (64) is coupled to the second fixed layer (53) of the second magnetic tunnel junction (50),
**characterized in that**
the storage chip further comprises a differential amplifier (70), wherein
a first input end (i1) of the differential amplifier (70) is coupled to the third electrode (63) of the storage component, and a second input end (i2) of the differential amplifier (70) is coupled to the fourth electrode (64) of the storage component.

2. The storage chip according to claim 1, wherein the second electrode (62), the third electrode (63), and the fourth electrode (64) are separately coupled to a reference ground end.

3. The storage chip according to claim 1 or 2, wherein a first input end (i1) of the differential amplifier (70) is coupled to multiple third electrodes (63), and a second input end (i2) of the differential amplifier (70) is coupled to multiple fourth electrodes (64); and
the storage chip further comprises a time-sharing read control circuit (80), wherein the time-sharing read control circuit (80) is coupled to the storage component, and is configured to send a time-sharing read instruction to the storage component, so that the multiple third electrodes (63) transmit signals to the first input end (i1) of the differential amplifier (70) in a time-sharing manner, and the multiple fourth electrodes (64) transmit signals to the second input end (i2) of the differential amplifier (70) in a time-sharing manner.

4. A preparation method of a storage chip comprising a storage component according to claim 1, comprising:
forming, on a substrate, a first magnetic tunnel junction (40), a spin orbit coupling layer (20), and a second magnetic tunnel junction (50) that are sequentially arranged in a stacked manner, wherein
the first magnetic tunnel junction (40) comprises a first free layer (41), the second magnetic tunnel junction (50) comprises a second free layer (51), and the first free layer (41) and the second free layer (51) are arranged on two opposite surfaces of the spin orbit coupling layer (20),
wherein the forming, on a substrate, a first magnetic tunnel junction (40), a spin orbit coupling layer (20), and a second magnetic tunnel junction (50) that are sequentially arranged in a stacked manner comprises:
forming a first fixed thin film (431) on the substrate;
forming a first tunneling thin film (421) on a surface that is of the first fixed thin film (431) and that is away from the substrate;
forming a first free thin film (411) on a surface that is of the first tunneling thin film (421) and that is away from the first fixed thin film (431);
forming a spin orbit coupling thin film (21) on a surface that is of the first free thin film (411) and that is away from the first tunneling thin film (421);
forming a second free thin film (511) on a surface that is of the spin orbit coupling thin film (21) and that is away from the first free thin film (411);
forming a second tunneling thin film (521) on a surface that is of the second free thin film (511) and that is away from the spin orbit coupling thin film (21);
forming a second fixed thin film (531) on a surface that is of the second tunneling thin film (521) and that is away from the second free thin film (511);
patterning the first fixed thin film (431), the first tunneling thin film (421), the first free thin film (411), the spin orbit coupling thin film (21), the second free thin film (511), the second tunneling thin film (521), and the second fixed thin film (531) by using a patterning process, to form the first magnetic tunnel junction (40) that is formed by sequentially stacking a first fixed layer (43), a first tunneling layer (42), and the first free layer (41), the spin orbit coupling layer (20), and the second magnetic tunnel junction (50) that is formed by sequentially stacking the second free layer (51), a second tunneling layer (52), and a second fixed layer (53);
coupling a first electrode (61) and a second electrode (62) to two opposite sides of the spin orbit coupling layer (20);
coupling a third electrode (63) to the first fixed layer (43) of the first magnetic tunnel junction (40), and coupling a fourth electrode (64) to the second fixed layer (53) of the second magnetic tunnel junction (50);
**characterized by**
coupling a first input end (i1) of the differential amplifier (70) to the third electrode (63) of the storage component, and coupling a second input end (i2) of the differential amplifier (70) to the fourth electrode (64) of the storage component.

5. A reading method of a storage component according to claim 1, wherein
the reading method of a storage component comprises:
applying a voltage signal to the spin orbit coupling layer (20);
reading an output current of the spin orbit coupling layer (20); and
obtaining, based on the output current of the spin orbit coupling layer (20), data stored in the first magnetic tunnel junction (40) and the second magnetic tunnel junction (50),
**characterized in that**
the obtaining, based on the output current of the spin orbit coupling layer (20), data stored in the first magnetic tunnel junction (40) and the second magnetic tunnel junction (50) comprises:
reading data corresponding to a low resistive state when Iout = Iin + Iish;
reading a medium resistive state when Iout = Iin + 1/2 Iish; or
reading a high resistive state when Iout = Iin, wherein
Iout is the output current of the spin orbit coupling layer (20), Iin is an in-plane current generated after the voltage signal is applied to the spin orbit coupling layer (20), and Iish is an inverse spin Hall current generated by an inverse spin Hall effect after the voltage signal is applied to the spin orbit coupling layer (20).

6. A reading method of a storage component according to claim 1, wherein
the reading method of a storage component comprises:
applying a voltage signal to the spin orbit coupling layer (20);
reading an output current of the first magnetic tunnel junction (40) and an output current of the second magnetic tunnel junction (50);
obtaining, based on the output current of the first magnetic tunnel junction (40) and the output current of the second magnetic tunnel junction (50), data stored in the first magnetic tunnel junction (40) and the second magnetic tunnel junction (50); and is
**characterized in that**
the obtaining, based on the output current of the first magnetic tunnel junction (40) and the output current of the second magnetic tunnel junction (50), data stored in the first magnetic tunnel junction (40) and the second magnetic tunnel junction (50) comprises:
reading a low resistive state when Iout' > 0;
reading a medium resistive state when Iout' = 0; or
reading a high resistive state when Iout' < 0, wherein
Iout' is a difference between the output current of the first magnetic tunnel junction (40) and the output current of the second magnetic tunnel junction (50).

7. A writing method of a storage component according to claim 1, wherein
the writing method of a storage component **is characterized by**
separately applying a voltage signal to the first magnetic tunnel junction, the second magnetic tunnel junction, and the spin orbit coupling layer, wherein
the voltage signal is used to change resistive states of the first magnetic tunnel junction and the second magnetic tunnel junction, so as to change a resistive state of the storage component, and write, into the storage component, data corresponding to the resistive state of the storage component.

8. An electronic device, comprising the storage chip according to any one of claims 1 to 3.

## Patentansprüche

1. Speicherchip, der eine Speicherkomponente umfasst, die einen ersten magnetischen Tunnelübergang (40), eine Spin-Bahn-Kopplungsschicht (20) und einen zweiten magnetischen Tunnelübergang (50) umfasst, die in einer gestapelten Weise sequenziell angeordnet sind, wobei
der erste magnetische Tunnelübergang (40) eine erste freie Schicht (41) umfasst und der zweite magnetische Tunnelübergang (50) eine zweite freie Schicht (51) umfasst; und
wobei die erste freie Schicht (41) und die zweite freie Schicht (51) auf zwei gegenüberliegenden Oberflächen der Spin-Bahn-Kopplungsschicht (20) angeordnet sind,
wobei der erste magnetische Tunnelübergang (40) ferner eine erste Tunnelschicht (42) und eine erste feste Schicht (43) umfasst, die in einer gestapelten Weise sequenziell auf der ersten freien Schicht (41) angeordnet sind; und/oder wobei der zweite magnetische Tunnelübergang (50) ferner eine zweite Tunnelschicht (52) und eine zweite feste Schicht (53) umfasst, die in einer gestapelten Weise sequenziell auf der zweiten freien Schicht (51) angeordnet sind,
wobei die Speicherkomponente ferner eine erste Elektrode (61) und eine zweite Elektrode (62) umfasst; und wobei die erste Elektrode (61) und die zweite Elektrode (62) mit zwei gegenüberliegenden Seiten der Spin-Bahn-Kopplungsschicht (20) gekoppelt sind,
wobei die Speicherkomponente ferner eine dritte Elektrode (63) und eine vierte Elektrode (64) umfasst; und wobei die dritte Elektrode (63) mit der ersten festen Schicht (43) des ersten magnetischen Tunnelübergangs (40) gekoppelt ist und die vierte Elektrode (64) mit der zweiten festen Schicht (53) des zweiten magnetischen Tunnelübergangs (50) gekoppelt ist,
**dadurch gekennzeichnet, dass**
der Speicherchip ferner einen Differenzverstärker (70) umfasst, wobei
ein erstes Eingangsende (i1) des Differenzverstärkers (70) mit der dritten Elektrode (63) der Speicherkomponente gekoppelt ist und ein zweites Eingangsende (i2) des Differenzverstärkers (70) mit der vierten Elektrode (64) der Speicherkomponente gekoppelt ist.

2. Speicherchip nach Anspruch 1, wobei die zweite Elektrode (62), die dritte Elektrode (63) und die vierte Elektrode (64) separat mit einem Referenzerdungsende gekoppelt sind.

3. Speicherchip nach Anspruch 1 oder 2, wobei ein erstes Eingangsende (i1) des Differenzverstärkers (70) mit mehreren dritten Elektroden (63) gekoppelt ist und ein zweites Eingangsende (i2) des Differenzverstärkers (70) mit mehreren vierten Elektroden (64) gekoppelt ist; und
wobei der Speicherchip ferner eine Zeitmultiplex-Lesesteuerschaltung (80) umfasst, wobei die Zeitmultiplex-Lesesteuerschaltung (80) mit der Speicherkomponente gekoppelt ist und konfiguriert ist zum Senden einer Zeitmultiplex-Leseanweisung an die Speicherkomponente, sodass die mehreren dritten Elektroden (63) Signale in einer Zeitmultiplex-Weise zu dem ersten Eingangsende (i1) des Differenzverstärkers (70) übertragen, und die mehreren vierten Elektroden (64) Signale in einer Zeitmultiplex-Weise zu dem zweiten Eingangsende (i2) des Differenzverstärkers (70) übertragen.

4. Vorbereitungsverfahren für einen Speicherchip, der eine Speicherkomponente umfasst, nach Anspruch 1, umfassend:
Bilden, auf einem Substrat, eines ersten magnetischen Tunnelübergangs (40), einer Spin-Bahn-Kopplungsschicht (20) und eines zweiten magnetischen Tunnelübergangs (50), die in einer gestapelten Weise sequenziell angeordnet werden, wobei
der erste magnetische Tunnelübergang (40) eine erste freie Schicht (41) umfasst, der zweite magnetische Tunnelübergang (50) eine zweite freie Schicht (51) umfasst und wobei die erste freie Schicht (41) und die zweite freie Schicht (51) auf zwei gegenüberliegenden Oberflächen der Spin-Bahn-Kopplungsschicht (20) angeordnet sind,
wobei das Bilden, auf einem Substrat, eines ersten magnetischen Tunnelübergangs (40), einer Spin-Bahn-Kopplungsschicht (20) und eines zweiten magnetischen Tunnelübergangs (50), die in einer gestapelten Weise sequenziell angeordnet werden, umfasst:
Bilden eines ersten festen Dünnfilms (431) auf dem Substrat;
Bilden eines ersten Tunneldünnfilms (421) auf einer Oberfläche, die aus dem ersten festen Dünnfilm (431) besteht und die von dem Substrat abgewandt ist;
Bilden eines ersten freien Dünnfilms (411) auf einer Oberfläche, die aus dem ersten Tunneldünnfilm (421) besteht und die von dem ersten festen Dünnfilm (431) abgewandt ist;
Bilden eines Spin-Bahn-Kopplungsdünnfilms (21) auf einer Oberfläche, die aus dem ersten freien Dünnfilm (411) besteht und die von dem ersten Tunneldünnfilm (421) abgewandt ist;
Bilden eines zweiten freien Dünnfilms (511) auf einer Oberfläche, die aus dem Spin-Bahn-Kopplungsdünnfilm (21) besteht und die von dem ersten freien Dünnfilm (411) abgewandt ist;
Bilden eines zweiten Tunneldünnfilms (521) auf einer Oberfläche, die aus dem zweiten freien Dünnfilm (511) besteht und die von dem Spin-Bahn-Kopplungsdünnfilm (21) abgewandt ist;
Bilden eines zweiten festen Dünnfilms (531) auf einer Oberfläche, die aus dem zweiten Tunneldünnfilm (521) besteht und die von dem zweiten freien Dünnfilm (511) abgewandt ist;
Strukturieren des ersten festen Dünnfilms (431), des ersten Tunneldünnfilms (421), des ersten freien Dünnfilms (411), des Spin-Bahn-Kopplungsdünnfilms (21), des zweiten freien Dünnfilms (511), des zweiten Tunneldünnfilms (521) und des zweiten festen Dünnfilms (531) unter Verwendung eines Strukturierungsprozesses, um den ersten magnetischen Tunnelübergang (40), der durch ein sequenzielles Stapeln einer ersten festen Schicht (43), einer ersten Tunnelschicht (42) und der ersten freien Schicht (41) gebildet wird, die Spin-Bahn-Kopplungsschicht (20) und den zweiten magnetischen Tunnelübergang (50) zu bilden, der durch ein sequenzielles Stapeln der zweiten freien Schicht (51), einer zweiten Tunnelschicht (52) und einer zweiten festen Schicht (53) gebildet wird;
Koppeln einer ersten Elektrode (61) und einer zweiten Elektrode (62) mit zwei gegenüberliegenden Seiten der Spin-Bahn-Kopplungsschicht (20);
Koppeln einer dritten Elektrode (63) mit der ersten festen Schicht (43) des ersten magnetischen Tunnelübergangs (40) und Koppeln einer vierten Elektrode (64) mit der zweiten festen Schicht (53) des zweiten magnetischen Tunnelübergangs (50);
**gekennzeichnet durch**
Koppeln eines ersten Eingangsendes (i1) des Differenzverstärkers (70) mit der dritten Elektrode (63) der Speicherkomponente und Koppeln eines zweiten Eingangsendes (i2) des Differenzverstärkers (70) mit der vierten Elektrode (64) der Speicherkomponente.

5. Leseverfahren einer Speicherkomponente nach Anspruch 1, wobei das Leseverfahren einer Speicherkomponente umfasst:
Anlegen eines Spannungssignals an die Spin-Bahn-Kopplungsschicht (20);
Lesen eines Ausgangsstroms der Spin-Bahn-Kopplungsschicht (20); und
Erhalten, basierend auf dem Ausgangsstrom der Spin-Bahn-Kopplungsschicht (20), von Daten, die in dem ersten magnetischen Tunnelübergang (40) und dem zweiten magnetischen Tunnelübergang (50) gespeichert sind,
**dadurch gekennzeichnet, dass**
das Erhalten, basierend auf dem Ausgangsstrom der Spin-Bahn-Kopplungsschicht (20), von Daten, die in dem ersten magnetischen Tunnelübergang (40) und dem zweiten magnetischen Tunnelübergang (50) gespeichert sind, umfasst:
Lesen von Daten, die einem Zustand mit niedrigem Widerstand entsprechen, wenn Iout = Iin + Iish ist;
Lesen eines Zustands mit mittlerem Widerstand, wenn Iout = Iin + 1/2 Iish ist; oder
Lesen eines Zustands mit hohem Widerstand, wenn Iout = Iin ist, wobei
Iout der Ausgangsstrom der Spin-Bahn-Kopplungsschicht (20) ist, Iin ein In-Plane-Strom ist, der erzeugt wird, nachdem das Spannungssignal an die Spin-Bahn-Kopplungsschicht (20) angelegt wurde, und Iish ein inverser Spin-Hall-Strom ist, der durch einen inversen Spin-Hall-Effekt erzeugt wird, nachdem das Spannungssignal an die Spin-Bahn-Kopplungsschicht (20) angelegt wurde.

6. Leseverfahren einer Speicherkomponente nach Anspruch 1, wobei das Leseverfahren einer Speicherkomponente umfasst:
Anlegen eines Spannungssignals an die Spin-Bahn-Kopplungsschicht (20);
Lesen eines Ausgangsstroms des ersten magnetischen Tunnelübergangs (40) und eines Ausgangsstroms des zweiten magnetischen Tunnelübergangs (50);
Erhalten, basierend auf dem Ausgangsstrom des ersten magnetischen Tunnelübergangs (40) und dem Ausgangsstrom des zweiten magnetischen Tunnelübergangs (50), von Daten, die in dem ersten magnetischen Tunnelübergang (40) und dem zweiten magnetischen Tunnelübergang (50) gespeichert sind; und
**dadurch gekennzeichnet, dass**
das Erhalten, basierend auf dem Ausgangsstrom des ersten magnetischen Tunnelübergangs (40) und dem Ausgangsstrom des zweiten magnetischen Tunnelübergangs (50), von Daten, die in dem ersten magnetischen Tunnelübergang (40) und dem zweiten magnetischen Tunnelübergang (50) gespeichert sind, umfasst:
Lesen eines Zustands mit niedrigem Widerstand, wenn Iout' > 0 ist;
Lesen eines Zustands mit mittlerem Widerstand, wenn Iout' = 0 ist; oder
Lesen eines Zustands mit hohem Widerstand, wenn Iout' < 0 ist, wobei
Iout' eine Differenz zwischen dem Ausgangsstrom des ersten magnetischen Tunnelübergangs (40) und dem Ausgangsstrom des zweiten magnetischen Tunnelübergangs (50) ist.

7. Schreibverfahren einer Speicherkomponente nach Anspruch 1, wobei das Schreibverfahren einer Speicherkomponente **gekennzeichnet ist durch** ein separates Anlegen eines Spannungssignals an den ersten magnetischen Tunnelübergang, den zweiten magnetischen Tunnelübergang und die Spin-Bahn-Kopplungsschicht, wobei
das Spannungssignal verwendet wird, um Widerstandszustände des ersten magnetischen Tunnelübergangs und des zweiten magnetischen Tunnelübergangs zu ändern, sodass ein Widerstandszustand der Speicherkomponente geändert wird und Daten, die dem Widerstandszustand der Speicherkomponente entsprechen, in die Speicherkomponente geschrieben werden.

8. Elektronische Vorrichtung, die den Speicherchip nach einem der Ansprüche 1 bis 3 umfasst.

## Revendications

1. Puce de stockage comprenant un composant de stockage, qui comprend une première jonction à effet tunnel magnétique (40), une couche de couplage spin-orbite (20), et une deuxième jonction à effet tunnel magnétique (50) qui sont agencées séquentiellement de manière empilée,
la première jonction à effet tunnel magnétique (40) comprenant une première couche libre (41), et la deuxième jonction à effet tunnel magnétique (50) comprenant une deuxième couche libre (51) ; et
la première couche libre (41) et la deuxième couche libre (51) étant disposées sur deux surfaces opposées de la couche de couplage spin-orbite (20),
la première jonction à effet tunnel magnétique (40) comprenant en outre une première couche à effet tunnel (42) et une première couche fixe (43) agencées séquentiellement sur la première couche libre (41) de manière empilée ; et/ou la deuxième jonction à effet tunnel magnétique (50) comprenant en outre une deuxième couche à effet tunnel (52) et une deuxième couche fixe (53) agencées séquentiellement sur la deuxième couche libre (51) de manière empilée,
le composant de stockage comprenant en outre une première électrode (61) et une deuxième électrode (62) ; et la première électrode (61) et la deuxième électrode (62) étant couplées à deux côtés opposés de la couche de couplage spin-orbite (20),
le composant de stockage comprenant en outre une troisième électrode (63) et une quatrième électrode (64) ; et la troisième électrode (63) étant couplée à la première couche fixe (43) de la première jonction à effet tunnel magnétique (40), et la quatrième électrode (64) étant couplée à la deuxième couche fixe (53) de la deuxième jonction à effet tunnel magnétique (50),
**caractérisée en ce que**
la puce de stockage comprend en outre un amplificateur différentiel (70),
une première extrémité d'entrée (i1) de l'amplificateur différentiel (70) étant couplée à la troisième électrode (63) du composant de stockage, et une deuxième extrémité d'entrée (i2) de l'amplificateur différentiel (70) étant couplée à la quatrième électrode (64) du composant de stockage.

2. Puce de stockage selon la revendication 1, la deuxième électrode (62), la troisième électrode (63) et la quatrième électrode (64) étant couplées séparément à une extrémité de masse de référence.

3. Puce de stockage selon la revendication 1 ou 2, une première extrémité d'entrée (i1) de l'amplificateur différentiel (70) étant couplée à de multiples troisièmes électrodes (63), et une deuxième extrémité d'entrée (i2) de l'amplificateur différentiel (70) étant couplée à de multiples quatrièmes électrodes (64) ; et
la puce de stockage comprenant en outre un circuit de commande de lecture à partage de temps (80), le circuit de commande de lecture à partage de temps (80) étant couplé au composant de stockage, et étant configuré pour envoyer une instruction de lecture à partage de temps au composant de stockage, de sorte que les multiples troisièmes électrodes (63) transmettent des signaux à la première extrémité d'entrée (i1) de l'amplificateur différentiel (70) de manière à partage de temps, et que les quatrièmes électrodes multiples (64) transmettent des signaux à la deuxième extrémité d'entrée (i2) de l'amplificateur différentiel (70) de manière à partage de temps.

4. Procédé de préparation d'une puce de stockage comprenant un composant de stockage selon la revendication 1, comprenant :
la formation, sur un substrat, d'une première jonction à effet tunnel magnétique (40), d'une couche de couplage spin-orbite (20) et d'une deuxième jonction à effet tunnel magnétique (50) qui sont agencées séquentiellement de manière empilée,
la première jonction à effet tunnel magnétique (40) comprenant une première couche libre (41), la deuxième jonction à effet tunnel magnétique (50) comprenant une deuxième couche libre (51), et la première couche libre (41) et la deuxième couche libre (51) étant agencées sur deux surfaces opposées de la couche de couplage spin-orbite (20),
la formation, sur un substrat, d'une première jonction à effet tunnel magnétique (40), d'une couche de couplage spin-orbite (20) et d'une deuxième jonction à effet tunnel magnétique (50) qui sont agencées séquentiellement de manière empilée comprenant :
la formation d'une première couche mince fixe (431) sur le substrat ;
la formation d'un premier film mince à effet tunnel (421) sur une surface du premier film mince fixe (431) éloignée du substrat ;
la formation d'un premier film mince libre (411) sur une surface du premier film mince à effet tunnel (421) éloignée du premier film mince fixe (431) ;
la formation d'un film mince de couplage spin-orbite (21) sur une surface du premier film mince libre (411) éloignée du premier film mince à effet tunnel (421) ;
la formation d'un deuxième film mince libre (511) sur une surface du film mince de couplage spin-orbite (21) éloignée du premier film mince libre (411) ;
la formation d'un deuxième film mince à effet tunnel (521) sur une surface du deuxième film mince libre (511) éloignée du film mince de couplage spin-orbite (21) ;
la formation d'un deuxième film mince fixe (531) sur une surface du deuxième film mince à effet tunnel (521) éloignée du deuxième film mince libre (511) ;
la structuration du premier film mince fixe (431), du premier film mince à effet tunnel (421), du premier film mince libre (411), du film mince à couplage spin-orbite (21), du deuxième film mince libre (511), du deuxième film mince à effet tunnel (521) et du deuxième film mince fixe (531) en utilisant un processus de structuration, pour former la première jonction à effet tunnel magnétique (40) formée par empilement séquentiel d'une première couche fixe (43), d'une première couche à effet tunnel (42), et la première couche libre (41), la couche de couplage spin-orbite (20), et la deuxième jonction à effet tunnel magnétique (50) formée par l'empilement séquentiel de la deuxième couche libre (51), d'une deuxième couche à effet tunnel (52), et d'une deuxième couche fixe (53) ;
coupler une première électrode (61) et une deuxième électrode (62) à deux côtés opposés de la couche de couplage spin-orbite (20) ;
le couplage d'une troisième électrode (63) à la première couche fixe (43) de la première jonction à effet tunnel magnétique (40), et le couplage d'une quatrième électrode (64) à la deuxième couche fixe (53) de la deuxième jonction à effet tunnel magnétique (50) ;
**caractérisé par**
le couplage d'une première extrémité d'entrée (i1) de l'amplificateur différentiel (70) à la troisième électrode (63) du composant de stockage, et le couplage d'une deuxième extrémité d'entrée (i2) de l'amplificateur différentiel (70) à la quatrième électrode (64) du composant de stockage.

5. Procédé de lecture d'un composant de stockage selon la revendication 1, le procédé de lecture d'un composant de stockage comprenant :
l'application d'un signal de tension sur la couche de couplage spin-orbite (20) ;
la lecture d'un courant de sortie de la couche de couplage spin-orbite (20) ; et
l'obtention, sur la base du courant de sortie de la couche de couplage spin-orbite (20), de données stockées dans la première jonction à effet tunnel magnétique (40) et la deuxième jonction à effet tunnel magnétique (50),
**caractérisé en ce que**
l'obtention, sur la base du courant de sortie de la couche de couplage spin-orbite (20), de données stockées dans la première jonction à effet tunnel magnétique (40) et la deuxième jonction à effet tunnel magnétique (50) comprend :
la lecture de données correspondant à un état résistif bas lorsque Iout = Iin + Iish ;
la lecture d'un état résistif moyen lorsque Iout = Iin + 1/2 Iish ; ou
la lecture d'un état résistif élevé lorsque Iout = Iin, dans lequel
Iout est le courant de sortie de la couche de couplage spin-orbite (20), Iin est un courant dans le plan généré après que le signal de tension a été appliqué à la couche de couplage spin-orbite (20), et Iish est un courant de Hall de spin inverse généré par un effet Hall de spin inverse après que le signal de tension a été appliqué à la couche de couplage spin-orbite (20).

6. Procédé de lecture d'un composant de stockage selon la revendication 1, le procédé de lecture d'un composant de stockage comprenant :
l'application d'un signal de tension sur la couche de couplage spin-orbite (20) ;
la lecture d'un courant de sortie de la première jonction à effet tunnel magnétique (40) et d'un courant de sortie de la deuxième jonction à effet tunnel magnétique (50) ;
l'obtention, sur la base du courant de sortie de la première jonction à effet tunnel magnétique (40) et du courant de sortie de la deuxième jonction à effet tunnel magnétique (50), de données stockées dans la première jonction à effet tunnel magnétique (40) et la deuxième jonction à effet tunnel magnétique (50) ; et étant
**caractérisé en ce que**
l'obtention, sur la base du courant de sortie de la première jonction à effet tunnel magnétique (40) et du courant de sortie de la deuxième jonction à effet tunnel magnétique (50), de données stockées dans la première jonction à effet tunnel magnétique (40) et la deuxième jonction à effet tunnel magnétique (50) comprend
la lecture d'un état résistif bas lorsque Iout' > 0 ;
la lecture d'un état résistif moyen lorsque Iout' = 0 ; ou
la lecture d'un état résistif élevé lorsque Iout' < 0, dans lequel
Iout' est une différence entre le courant de sortie de la première jonction à effet tunnel magnétique (40) et le courant de sortie de la deuxième jonction à effet tunnel magnétique (50).

7. Procédé d'écriture d'un composant de stockage selon la revendication 1, le procédé d'écriture d'un composant de stockage étant **caractérisé par** l'application séparée d'un signal de tension à la première jonction à effet tunnel magnétique, à la deuxième jonction à effet tunnel magnétique et à la couche de couplage spin-orbite,
le signal de tension étant utilisé pour modifier des états résistifs de la première jonction à effet tunnel magnétique et de la deuxième jonction à effet tunnel magnétique, de manière à modifier un état résistif du composant de stockage, et à écrire, dans le composant de stockage, des données correspondant à l'état résistif du composant de stockage.

8. Dispositif électronique, comprenant la puce de stockage selon l'une quelconque des revendications 1 à 3.
